(19) Europäisches Patentamt
European Patent Office
Office européen des brevets

(11) EP 2 339 400 A2

(12) **EUROPEAN PATENT APPLICATION**

(43) Date of publication:
**29.06.2011 Bulletin 2011/26**

(21) Application number: **10196773.5**

(22) Date of filing: **23.12.2010**

(51) Int Cl.:
***G03F 7/033*** *(2006.01)* ***G03F 7/038*** *(2006.01)*
***B41C 1/10*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.12.2009 JP 2009296420**
**15.10.2010 JP 2010232837**

(71) Applicant: **Fujifilm Corporation**
**Minato-ku**
**Tokyo (JP)**

(72) Inventors:
- **Koyama, Ichiro**
  **Shizuoka (JP)**
- **Oohashi, Hidekazu**
  **Shizuoka (JP)**

(74) Representative: **HOFFMANN EITLE**
**Patent- und Rechtsanwälte**
**Arabellastraße 4**
**81925 München (DE)**

(54) **Lithographic printing plate precursor and plate making method thereof**

(57) The invention is directed to provide a lithographic printing plate precursor which provides the good scratch resistance without accompanying degradation of the printing durability, chemical resistance and on-press development property, and a lithographic printing plate precursor capable of undergoing on-press development comprising a support and an image-recording layer containing (A) a binder polymer containing a repeating unit having a hydrocarbon group containing an alicyclic condensed ring structure in its side chain, a repeating unit having at least one hydrophilic group selected from a hydroxy group, an amino group, an amido group, a sulfonic acid group and an alkyleneoxide chain in its side chain and a repeating unit having a cyano group in its side chain, (B) an organic polymer particle, (C) a radical generator, (D) an infrared absorbing agent, and (E) a radical polymerizable compound, wherein a combination of the repeating unit having a condensed ring structure in its side chain and the repeating unit having a hydrophilic group in its side chain in (A) the binder polymer fulfills the specific condition is provided.

EP 2 339 400 A2

**Description**

FIELD OF THE INVENTION

The present invention relates to a lithographic printing plate precursor and a plate making method using the same. More particularly, it relates to a lithographic printing plate precursor capable of undergoing a direct plate making by image exposure with laser and a plate making method comprising on-press development of the lithographic printing plate precursor.

BACKGROUND OF THE INVENTION

In general, a lithographic printing plate is composed of an oleophilic image area accepting ink and a hydrophilic non-image area accepting dampening water (fountain solution) in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.
In order to produce the lithographic printing plate, a lithographic printing plate precursor (PS plate) comprising a hydrophilic support having provided thereon an oleophilic photosensitive resin layer (image-recording layer) is used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.
Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.
With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.
In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing step.
Also, as a method of simple development, a method referred to as a "gum development" is practiced wherein the removal of the unnecessary area of image-recording layer is performed using not a conventional high alkaline developer but a finisher or gum solution of near-neutral pH.
In the simplification of plate making operation as described above, a system using a lithographic printing plate precursor capable of being handled in a bright room or under a yellow lump and a light source is preferable from the standpoint of workability. Thus, as the light source, a semiconductor laser emitting an infrared ray having a wavelength of 760 to 1,200 or a solid laser, for example, YAG laser, is used. An UV laser is also used.
As the lithographic printing plate precursor capable of undergoing on-press development, for instance, a lithographic printing plate precursor having provided on a hydrophilic support, an image-recording layer containing microcapsules having a polymerizable compound encapsulated therein is described in JP-A-2001-277740 (the term "JP-A" as used herein means an "unexamined published Japanese patent application") and JP-A-2001-277742. Also, a lithographic printing plate precursor having provided on a support, an image-recording layer containing an infrared absorbing agent, a radical polymerization initiator and a polymerizable compound is described in JP-A-2002-287334. Further, a lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in U.S. Patent Publication No. 2003/0064318. However, the technique is insufficient in scratch resistance, printing durability and chemical resistance, although it is good in on-press development property.
Moreover, a lithographic printing plate precursor capable of undergoing on-press development having provided on a support, an image-recording layer containing a binder polymer having a cyano group and a hydrophilic group in its molecule is described in JP-A-2009-241257. The technique is still insufficient in the scratch resistance and printing

durability, although it is good in the chemical resistance.

The term "chemical resistance" as used herein means resistance of the image-recording layer against a solvent used for washing out ink when the printing late is contaminated at the time of printing.

A lithographic printing plate precursor utilizing a polymer having a pendant adamantyl group is described in JP-T-2009-517720 (the term "JP-T" as used herein means a published Japanese translation of a PCT patent application). However, the technique has a construction intending not to the on-press development but to an alkali development, although it is good in the chemical resistance and heat resistance. Further, it is still insufficient in the printing durability and scratch resistance.

## SUMMARY OF THE INVENTION

An object of the present invention is to provide a lithographic printing plate precursor which provides good scratch resistance without accompanying degradation of existing printing durability, chemical resistance and on-press development property.

The present invention includes the following items.

(1) A lithographic printing plate precursor capable of undergoing on-press development comprising a support and an image-recording layer containing (A) a binder polymer containing a repeating unit having a hydrocarbon group containing an alicyclic condensed ring structure in its side chain, a repeating unit having at least one hydrophilic group selected from a hydroxy group, an amino group, an amido group, a sulfonic acid group and an alkyleneoxide chain in its side chain and a repeating unit having a cyano group in its side chain, (B) an organic polymer particle, (C) a radical generator, (D) an infrared absorbing agent, and (E) a radical polymerizable compound, wherein a combination of the repeating unit having a condensed ring structure in its side chain and the repeating unit having a hydrophilic group in its side chain in (A) the binder polymer is any combination selected from 1) to 3) shown below:

1) combination where the condensed ring structure is an adamantane skeleton and the hydrophilic group is a group represented by formula 3 shown below,
2) combination where the condensed ring structure is a norbornane skeleton and the hydrophilic group is at least any group selected from an amido group and a group represented by formula 3 shown below,
3) combination where the condensed ring structure contain neither the adamantane skeleton nor the norbornane skeleton and the hydrophilic group is a group selected from a hydroxy group, an amino group, an amido group, a sulfonic acid group and a group represented by formula 3 shown below.

Formula 3:

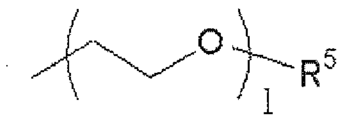

In formula 3, $R^5$ represents a hydrogen atom, an alkyl group, an aryl group, -C(=O)-R or -C(=O)-O-R R represents an alkyl group, an alkenyl group, an alkynyl group or an aryl group each having 20 or less carbon atoms, and 1 represents an integer from 2 to 90.

(2) The lithographic printing plate precursor as described in (1) above, wherein (A) the binder polymer is a vinyl copolymer.

(3) The lithographic printing plate precursor as described in (1) or (2) above, wherein the repeating unit having a hydrocarbon group containing an alicyclic condensed ring structure in its side chain in (A) the binder polymer is a repeating unit represented by formula 1 shown below.

Formula 1:

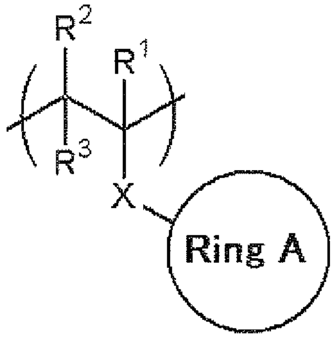

In formula 1, $R^1$ represents a hydrogen atom or a methyl group, $R^2$ and $R^3$ each independently represents a hydrogen atom, an alkyl group or an aryl group, X represents a single bond or a difunctional connecting group, and Ring A represents an alicyclic hydrocarbon group having a condensed ring structure containing at least one 5-membered or 6-membered ring.

(4) The lithographic printing plate precursor as described in (3) above, wherein a number of carbon atoms contained in the Ring A in formula 1 is from 7 to 25.

(5) The lithographic printing plate precursor as described in (3) or (4) above, wherein X in formula 1 is -CO-O-.

(6) The lithographic printing plate precursor as described in any one of (3) to (5) above, wherein the Ring A in formula 1 is an alicyclic hydrocarbon group selected from a group shown below and the hydrophilic group is a group selected from a hydroxy group, an amino group, an amido group, a sulfonic acid group and a group represented by formula 3 shown above.

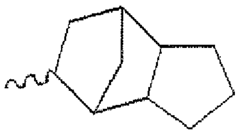 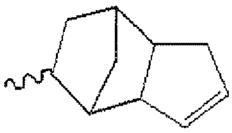 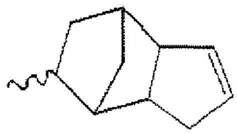 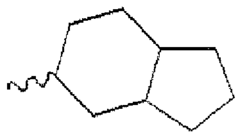

indicates a connecting position to the connecting group represented by X

(7) The lithographic printing plate precursor as described in any one of (1) to (6) above, wherein the repeating unit having a hydrophilic group in its side chain in (A) the binder polymer is a repeating unit represented by formula 2 shown below.

Formula 2:

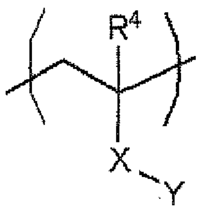

In formula 2, $R^4$ represents a hydrogen atom or a methyl group, X represents a single bond or a difunctional connecting group, and Y represents a hydrophilic group selected from a hydroxy group, an amino group, an amido group, a sulfonic acid group and a group represented by formula 3 shown above.

(8) The lithographic printing plate precursor as described in (7) above, wherein the repeating unit having a hydrophilic group in its side chain in (A) the binder polymer is a repeating unit represented by formula 4 or 5 shown below.

Formula 4:

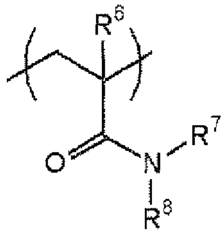

Formula 5:

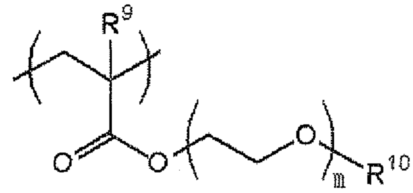

In formulae 4 and 5, $R^6$ represents a hydrogen atom or a methyl group, $R^7$ and $R^8$ each independently represents a hydrogen atom, an alkyl group, an aryl group or a group represented by formula 6 shown below, or $R^7$ and $R^8$ may be combined with each other to form a ring, $R^9$ represents a hydrogen atom or a methyl group, $R^{10}$ represents a hydrogen atom, an alkyl group or an aryl group, and m represents an integer from 2 to 90.

Formula 6:

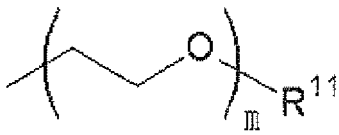

In formula 6, $R^{11}$ and m have the same meanings as $R^5$ and 1 defined in formula 3, respectively.

(9) The lithographic printing plate precursor as described in (7) or (8) above, wherein $R^7$ in formula 4 is a hydrogen atom or a group represented by formula 6 above and $R^8$ is a hydrogen atom, an alkyl group having 12 or less carbon atoms or a group represented by formula 6 above.

(10) The lithographic printing plate precursor as described in (9) above, wherein $R^7$ in formula 4 is a hydrogen atom and $R^8$ is a group represented by formula 6 above.

(11) The lithographic printing plate precursor as described in any one of (1) to (10) above, wherein the repeating unit having a cyano group in its side chain in (A) the binder polymer is a repeating unit represented by formula 7 shown below.

Formula 7:

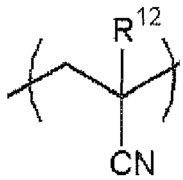

In formula 7, $R^{12}$ represents a hydrogen atom or an alkyl group.

(12) The lithographic printing plate precursor as described in any one of (1) to (11) above, wherein (A) the binder polymer contains from 5 to 35% by mole of the repeating unit having a hydrocarbon group containing an alicyclic condensed ring structure in its side chain, from 5 to 40% by mole of the repeating unit having a hydrophilic group in its side chain and 50 to 80% by mole of the repeating unit having a cyano group in its side chain.

(13) The lithographic printing plate precursor as described in any one of (1) to (12) above, wherein (A) the binder polymer is a polymer containing a repeating unit having an ethylenically unsaturated bond in its side chain.

(14) The lithographic printing plate precursor as described in any one of (1) to (13) above, wherein (B) the organic polymer particle is a copolymer containing acrylonitrile or methacrylonitrile.

(15) The lithographic printing plate precursor as described in (14) above, wherein (B) the organic polymer particle further contains styrene and a repeating unit having a polyalkylene oxide segment.

(16) The lithographic printing plate precursor as described in any one of (1) to (15) above, which further comprises a protective layer on the image-recording layer.

(17) A plate making method of a lithographic printing plate comprising exposing imagewise the lithographic printing plate precursor as described in any one of (1) to (16) above, mounting the exposed lithographic printing plate precursor on a printing machine, and supplying at least any one of dampening water and ink to remove an unexposed area of the image-recording layer.

According to the invention, the scratch resistance can be imparted to the image-recording layer without accompanying degradation of the printing durability, chemical resistance and on-press development property by incorporating a condensed ring structure into the binder polymer of the image-recording layer.

The functional mechanism of the invention is not quite clear but it is presumed that by the introduction of a condensed ring structure into the binder polymer, toughness based on the condensed ring structure also generates on the surface of the image-recording layer containing the binder polymer. On the other hand, high hydrophobicity and cohesiveness of the condensed ring structure may deteriorate the chemical resistance and on-press development property. However, it is believed that the chemical resistance and on-press development property of the binder polymer as a whole can be maintained in a good range by the combination with a specific hydrophilic group.

According to the present invention, a lithographic printing plate precursor which provides good scratch resistance without accompanying degradation of the printing durability, chemical resistance and on-press development property can be provided.

DETAILED DESCRIPTION OF THE INVENTION

[Lithographic printing plate precursor]

The lithographic printing plate precursor capable of undergoing on-press development according to the invention comprises a support and an image-recording layer containing (A) a binder polymer containing a repeating unit having a hydrocarbon group containing an alicyclic condensed ring structure in its side chain, a repeating unit having at least one hydrophilic group selected from a hydroxy group, an amino group, an amido group, a sulfonic acid group and an alkyleneoxide chain in its side chain and a repeating unit having a cyano group in its side chain, (B) an organic polymer particle, (C) a radical generator, (D) an infrared absorbing agent, and (E) a radical polymerizable compound, wherein a combination of the repeating unit having a condensed ring structure in its side chain and the repeating unit having a hydrophilic group in its side chain in (A) the binder polymer is any combination selected from 1) to 3) shown below:

1) combination where the condensed ring structure is an adamantane skeleton and the hydroxy group is a group represented by formula 3 shown below,
2) combination where the condensed ring structure is a norbornane skeleton and the hydroxy group is at least any group selected from an amido group and a group represented by formula 3 shown below,
3) combination where the condensed ring structure contain neither the adamantane skeleton nor the norbornane skeleton and the hydroxy group is a group selected from a hydroxy group, an amino group, an amido group, a sulfonic acid group and a group represented by formula 3 shown below.

Formula 3:

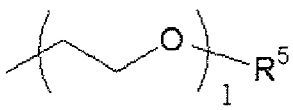

In formula 3, $R^5$ represents a hydrogen atom, an alkyl group, an aryl group, -C(=O)-R or -C(=O)-O-R, R represents an alkyl group, an alkenyl group, an alkynyl group or an aryl group each having 20 or less carbon atoms, and 1 represents an integer from 2 to 90.

The image-recording layer is capable of undergoing on-press development. The lithographic printing plate precursor according to the invention may have a protective layer on the image-recording layer and/or an undercoat layer between the support and the image-recording layer, if desired.

The constituting element, component and the like of the lithographic printing plate precursor according to the invention will be described below.

(Image-recording layer)

(A) Binder polymer

The binder polymer (hereinafter referred to as a specific polymer compound) containing a repeating unit having a hydrocarbon group containing an alicyclic condensed ring structure in its side chain, a repeating unit having at least one hydrophilic group selected from a hydroxy group, an amino group, an amido group, a sulfonic acid group and an alkyleneoxide chain in its side chain and a repeating unit having a cyano group in its side chain, which is one feature of the invention, is described below. By incorporating the specific polymer compound into the image-recording layer, the scratch resistance is obtained in addition to the chemical resistance and on-press development property.

Further, the specific polymer compound is preferably a vinyl copolymer in the invention.

[Repeating unit having hydrocarbon group containing an alicyclic condensed ring structure in its side chain]

The specific polymer compound contains a hydrocarbon group containing an alicyclic condensed ring structure in its side chain. The hydrocarbon group containing an alicyclic condensed ring structure increases the strength of the image-recording layer due to the structure toughness and is effective to improve the printing durability and scratch resistance. The repeating unit having the condensed ring structure in its side chain includes preferably a repeating unit represented by formula 1 shown below.

Formula 1

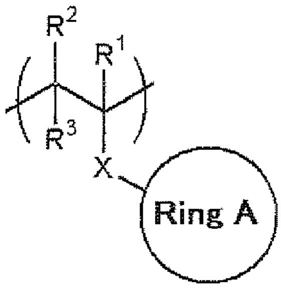

in formula 1, $R^1$ represents a hydrogen atom or a methyl group, $R^2$ and $R^3$ each independently represents a hydrogen atom, an alkyl group or an aryl group each of which may have a substituent in an appropriate position, X represents a single bond or a difunctional connecting group (a divalent connecting group), and Ring A represents an alicyclic hydrocarbon group having a condensed ring structure containing at least one 5-membered or 6-membered ring.

According to the invention, both $R^2$ and $R^3$ are particularly preferably hydrogen atoms. X preferably includes, for example, a single bond, an alkylene group having 20 or less carbon atoms, a cycloalkylene group having 20 or less carbon atoms, a polyalkyleneoxide group having a repeating number from 1 to 10, an arylene group, for example, a phenylene group or a naphthylene group, a difunctional connecting group having the structure shown below and a combination thereof.

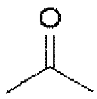 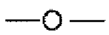 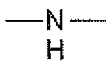 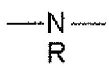 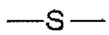

Above all, a phenylene group and connecting groups (a) to (d) shown below are preferred and the connecting groups (a) to (d) are more preferred.

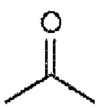
(a)

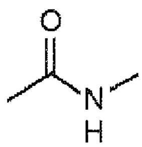
(b)

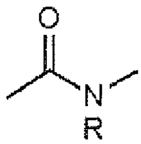
(c)

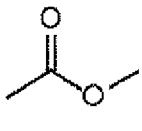
(d)

Of the connecting groups (a) to (d) shown above, the connecting groups (b), (c) and (d) are more preferred, and the connecting group (d) (-CO-O-) is most preferred.

R in the connecting group represents an alkyl group having 20 or less carbon atoms including, for example, a methyl group or an ethyl group, an alkenyl group having 20 or less carbon atoms, an alkynyl group having 20 or less carbon atoms or an aryl having 20 or less carbon atoms including, for example, a phenyl group or a naphthyl group.

The Ring A is preferably a ring having a number of carbon atoms (not including those of a substituent) constituting the condensed skeleton from 7 to 25 from the stand point of the ease in synthesis, stability and developing property, and more preferably a structure selected from the groups represented by formulae A-1 to A-13 shown below. Above all, a ring having a number of carbon atoms (not including those of a substituent) constituting the condensed skeleton from 7 to 12 is more preferred and a ring having a number of carbon atoms (not including those of a substituent) constituting the condensed skeleton from 7 to 10 is particularly preferred. The structures selected from the groups represented by formulae A-1, to A-5 are more preferred and the structures selected from the groups represented by formulae A-1 and A-2 are most preferred.

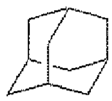
A-1

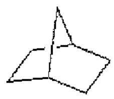
A-2

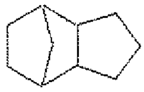
A-3

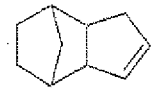
A-4

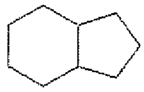
A-5

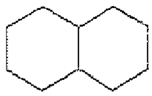
A-6

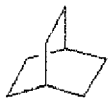
A-7

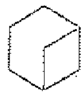
A-8

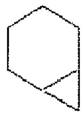
A-9

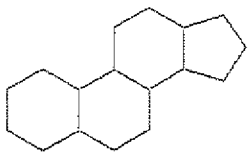
A-10

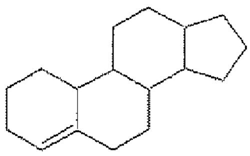
A-11

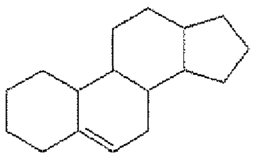
A-12

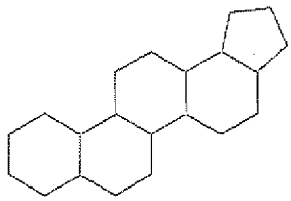
A-13

In the Ring A, a hydrogen atom(s) in an appropriate position(s) may be substituted with an appropriate structure. The structure includes, for example, a halogen atom, an alkyl group having 20 or less carbon atoms including, for example, a methyl group or an ethyl group, an alkenyl group having 20 or less carbon atoms, an alkynyl group having 20 or less carbon atoms or an aryl having 20 or less carbon atoms including, for example, a phenyl group or a naphthyl group, -CN, -C(=O)-R, -C(=O)-OR, -O-C(=O)-R, $-NH_2$, -NHR, -NRR', $NO_2$, -OH, -OR, a phosphoric acid group, -SH, -SR, a sulfonic acid group, =O, $=CH_2$, =CHR and =CRR'. Further, an aromatic ring having 20 or less carbon atoms including a phenyl group or a naphthyl group or a heterocyclic ring having 20 or less carbon atoms and containing a nitrogen atom, an oxygen atom or a sulfur atom, for example, an epoxy ring, a furan ring or a pyrrole ring may be condensed to a part of the ring. R and R' each independently represents an alkyl group having 20 or less carbon atoms including, for example, a methyl group or an ethyl group, an alkenyl group having 20 or less carbon atoms, an alkynyl group having 20 or less carbon atoms or an aryl having 20 or less carbon atoms including, for example, a phenyl group or a naphthyl group.

Specific examples of the ring structure having a substituent are set forth below.

B − 1 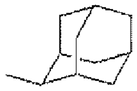 B − 2 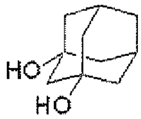 B − 3 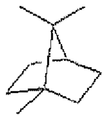 B − 4 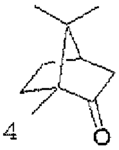

B − 5 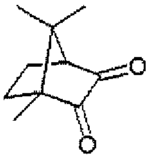 B − 6 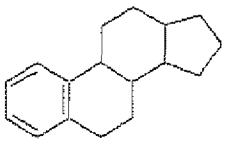 B − 7 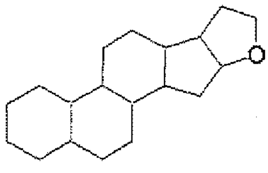 B − 8 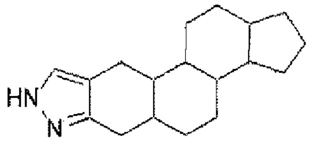

The content of the repeating unit having a hydrocarbon group containing an alicyclic condensed ring structure in its side chain in the specific polymer compound is preferably from 5 to 35% by mole, more preferably from 5 to 25% by mole, and most preferably from 10 to 15% by mole. In the range described above, good scratch resistance and on-press development property are obtained.

In order to introduce the repeating unit having a hydrocarbon group containing an alicyclic condensed ring structure in its side chain into the specific polymer compound, for example, a monomer having the hydrocarbon group containing an alicyclic condensed ring structure in its side chain may be copolymerized using a known polymerization initiator in an appropriate solvent.

Examples of the monomer having a hydrocarbon group containing an alicyclic condensed ring structure in its side chain preferably used in the invention are set forth below.

C − 1 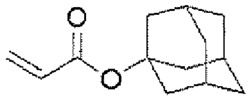 C − 2 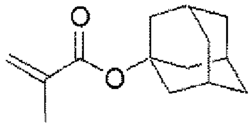

C − 3 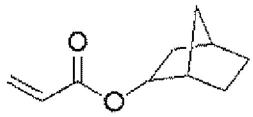 C − 4 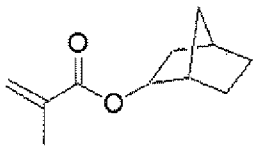

C − 5 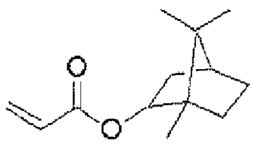 C − 6 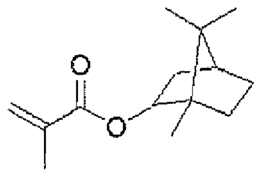

C − 7 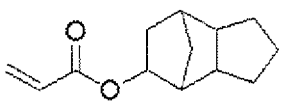 C − 8 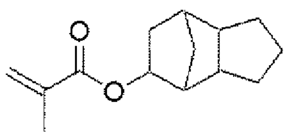

C-9
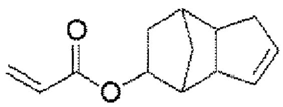

C-10
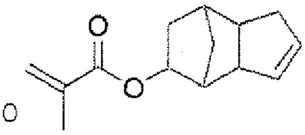

C-11
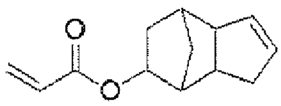

C-12
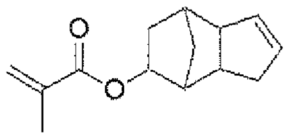

C-13
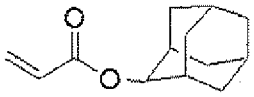

C-14
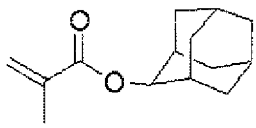

C-15
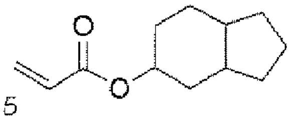

C-16
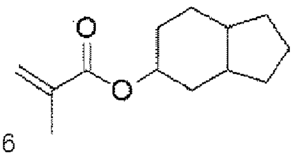

C-17
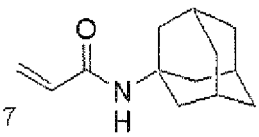

C-18
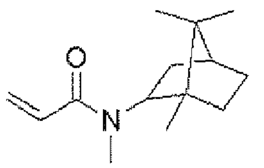

[Repeating unit having hydrophilic group in its side chain]

The specific polymer compound according to the invention contains at least one hydrophilic group selected from a hydroxy group, an amino group, an amido group, a sulfonic acid group and an alkyleneoxide chain.

In the specific polymer compound, a combination of the repeating unit having a condensed ring structure in its side chain and the repeating unit having a hydrophilic group in its side chain is as shown below.

1) combination where the condensed ring structure is an adamantane skeleton and the hydrophilic group is a group represented by formula 3 shown below,
2) combination where the condensed ring structure is a norbornane skeleton and the hydrophilic group is at least any group selected from an amido group and a group represented by formula 3 shown below,
3) combination where the condensed ring structure contain neither the adamantane skeleton nor the norbornane skeleton and the hydrophilic group is a group selected from a hydroxy group, an amino group, an amido group, a sulfonic acid group and a group represented by formula 3 shown below.

Formula 3:

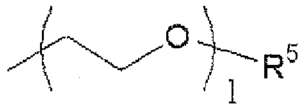

In formula 3, $R^5$ represents a hydrogen atom, an alkyl group, an aryl group, -C(=O)-R or -C(=O)-O-R, R represents an alkyl group, an alkenyl group, an alkynyl group or an aryl group each having 20 or less carbon atoms, and 1 represents an integer from 2 to 90.

The hydrophilic group has an effect of improving a problem in that the components of the image-recording layer formed by the on-press development generate scum on a water supplying roller or an ink roller to deteriorate a maintenance property of a printing machine and quality of printing in addition to an effect of accelerating the on-press development of the image-recording layer. The repeating unit having the hydrophilic group in its side chain includes preferably a repeating unit represented by formula 2 shown below.

Formula 2:

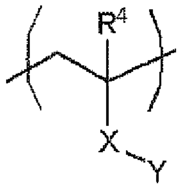

In formula 2, $R^4$ represents a hydrogen atom or a methyl group, X has the same meaning as X defined in formula 1, and Y represents a hydrophilic group selected from a hydroxy group, an amino group, an amido group, a sulfonic acid group and a group represented by formula 3 shown above.

In formula 3, $R^5$ represents a hydrogen atom, an alkyl group, an aryl group, -C(=O)-R or -C(=O)-O-R. The alkyl group is preferably that having 20 or less carbon atoms, more preferably that having 10 or less carbon atoms, still more preferably that having 2 or less carbon atoms, and most preferably a methyl group. The aryl group is preferably that having 20 or less carbon atoms, more preferably a phenyl group or a naphthyl group, and most preferably a phenyl group. Of these groups, a methyl group is most preferred.

R represents an alkyl group having 20 or less carbon atoms, an alkenyl group having 20 or less carbon atoms, an alkynyl group having 20 or less carbon atoms or an aryl group having 20 or less carbon atoms.

1 represents an integer from 2 to 90. 1 is preferably from 2 to 45, more preferably from 2 to 20, and most preferably from 2 to 5. The group represented by formula 3 may be a single group or a group having composition constructed from plural groups having different numbers in 1.

Of the hydrophilic groups represented by Y, an amido group and the group represented by formula 3 are more preferred. Further, with respect to the combination thereof with the repeating unit having a condensed ring structure, combinations 1) to 3) shown below are preferred mainly from the standpoint of the on-press development property, printing durability and scratch resistance.

1) combination of the condensed ring structure of an adamantane skeleton with the group represented by formula 3 wherein 1 is from 2 to 5,
2) combination of the condensed ring structure of a norbornane skeleton with an amido group and/or the group represented by formula 3 wherein 1 is from 2 to 5,
3) combination of the condensed ring structure containing neither the adamantane skeleton nor the norbornane skeleton with an amido group and/or the group represented by formula 3 wherein 1 is from 2 to 5.

The condensed ring structure in case of 3) preferably includes structures shown below.

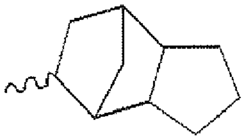 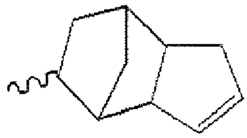 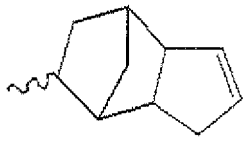 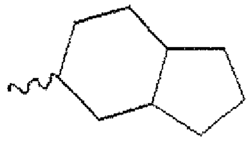 

indicates a connecting position to the connecting group represented by X

The repeating unit having an amido group as the hydrophilic group in its side chain preferably includes a repeating unit represented by formula 4 shown below.

Formula 4:

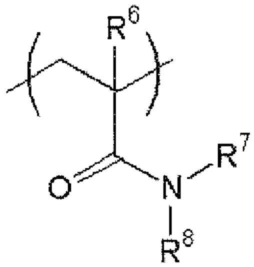

In formula 4, $R^6$ represents a hydrogen atom or a methyl group, $R^7$ and $R^8$ each independently represents a hydrogen atom, an alkyl group, an aryl group or a group represented by formula 6 shown below, or $R^7$ and $R^8$ may be combined with each other to form a ring.

More preferably, in formula 4, $R^7$ is a hydrogen atom or a group represented by formula 6 and $R^8$ is a hydrogen atom, an alkyl group having 12 or less carbon atoms or a group represented by formula 6. Most preferably, in formula 4, $R^7$ is a hydrogen atom or a group represented by formula 6 and $R^8$ is a group represented by formula 6.

Formula 6:

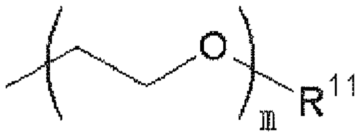

In formula 6, $R^{11}$ and m have the same meanings as $R^5$ and 1 defined in formula 3, respectively.

As the repeating unit having a group represented by formula 3 as the hydrophilic group in its side chain, a repeating unit represented by formula 5 shown below is also preferred.

Formula 5:

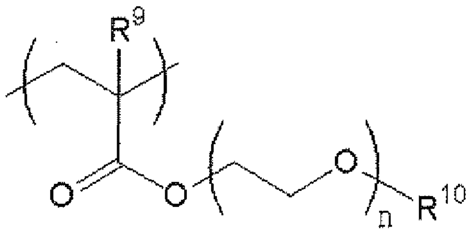

In formula 5, $R^9$ represents a hydrogen atom or a methyl group, and $R^{10}$ and n have the same meanings as $R^5$ and 1 defined in formula 3, respectively.

The content of the repeating unit having a hydrophilic group in its side chain in the specific polymer compound is preferably from 5 to 40% by mole, more preferably from 15 to 40% by mole, and most preferably from 15 to 25% by mole. In the range described above, good printing durability and on-press development property are obtained.

In order to introduce the repeating unit having a hydrophilic group in its side chain into the specific polymer compound, for example, a monomer having the hydrophilic group in its side chain may be copolymerized using a known

polymerization initiator in an appropriate solvent.

Examples of the monomer having a hydrophilic group in its side chain preferably used in the invention are set forth below.

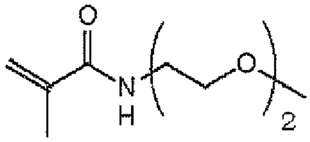
D-1

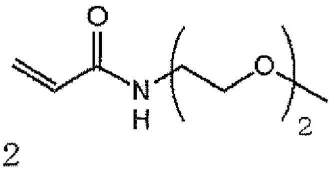
D-2

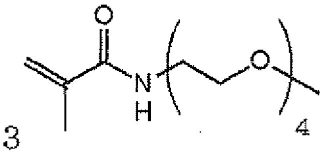
D-3

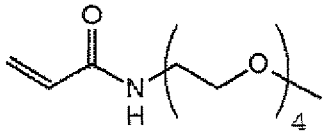
D-4

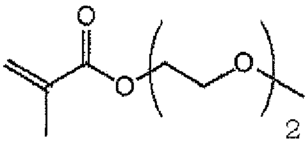
D-5

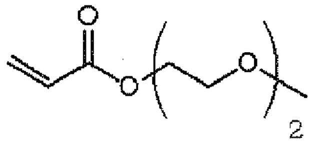
D-6

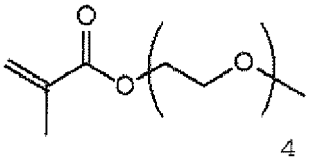
D-7

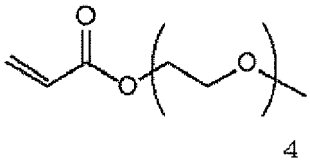
D-8

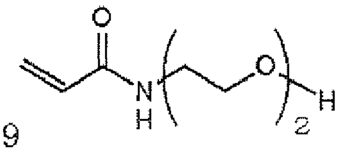
D-9

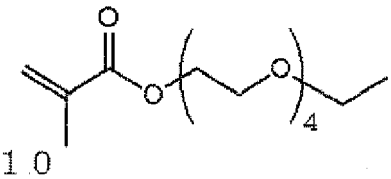
D-10

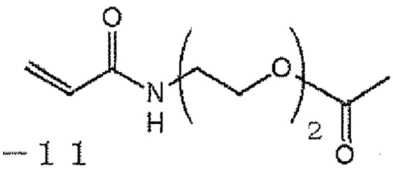
D-11

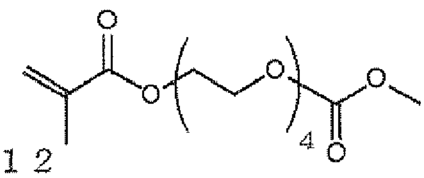
D-12

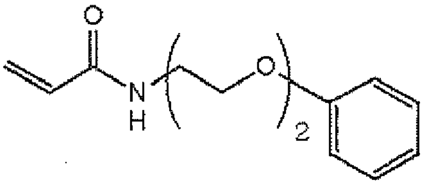

D-13

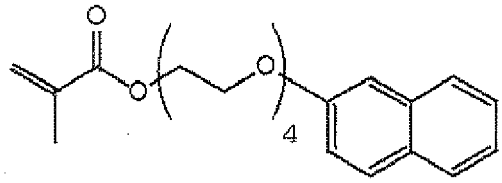

D-14

[Repeating unit having cyano group in its side chain]

The specific polymer compound according to the invention contains a cyano group. The cyano group imparts cohesiveness to the binder and prevents penetration of solvent into the image-recording layer to improve the chemical resistance.

The repeating unit having a cyano group in its side chain preferably includes a repeating unit represented by formula 7 shown below.

Formula 7:

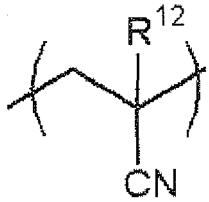

In formula 7, $R^{12}$ represents a hydrogen atom or an alkyl group. $R^{12}$ is preferably a hydrogen atom or a methyl group, and most preferably a hydrogen atom.

In order to introduce the repeating unit having a cyano group into the specific polymer compound, for example, a monomer having a cyano group in its side chain may be copolymerized using a known polymerization initiator in an appropriate solvent.

Examples of the monomer having a cyano group in its side chain preferably used in the invention include acrylonitrile, methacrylonitrile and α-cyanomethylacrylonitrile. Above all, acrylonitrile and methacrylonitrile are preferred.

The repeating unit having a cyano group in its side chain also includes repeating units formed from monomers shown below in addition to the above.

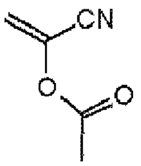
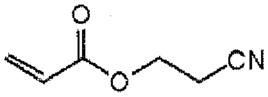
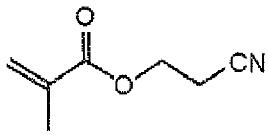
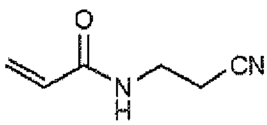

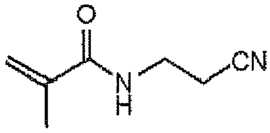
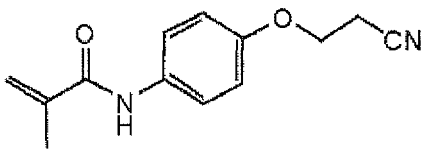
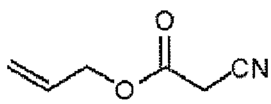

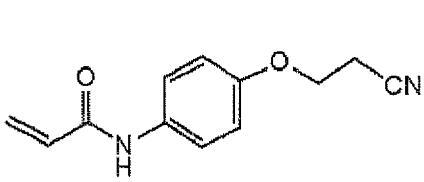 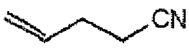 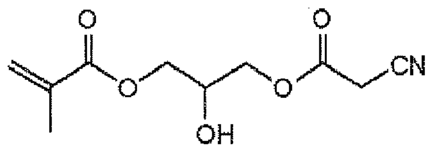

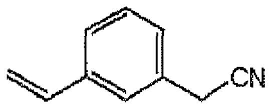

Of the repeating units having a cyano group in their side chain described above, the repeating unit represented by formula 7 is particularly preferred.

The content of the repeating unit having a cyano group in its side chain in the specific polymer compound is preferably from 50 to 80% by mole, more preferably from 60 to 80% by mole, and most preferably from 60 to 70% by mole. In the range described above, good printing durability and chemical resistance are obtained.

[Specific polymer compound having crosslinkable group]

The specific polymer compound according to the invention preferably contains a crosslinkable group in order to improve film strength of the image area. For the purpose, the specific polymer compound preferably contains a repeating unit having an ethylenically unsaturated bond in its side chain. In particular, an acryloyl group or a methacryloyl group is more preferred. The repeating unit having an ethylenically unsaturated bond in its side chain preferably includes a repeating unit represented by formula 8 shown below.

Formula 8:

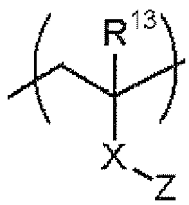

In formula 8, $R^{13}$ represents a hydrogen atom or a methyl group, X represents a single bond or a difunctional connecting group same as X defined in formula 1, and Z represents a group containing an ethylenically unsaturated bond.

Specific examples for Z include groups shown below.

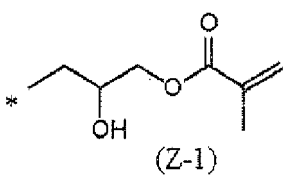
(Z-1)

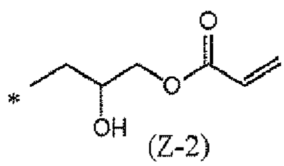
(Z-2)

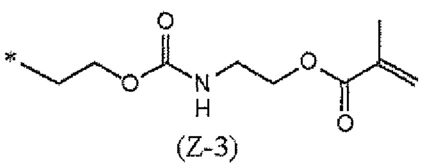
(Z-3)

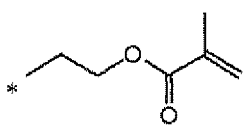
(Z-4)

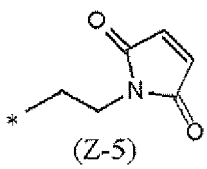
(Z-5)

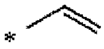
(Z-6)
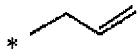
(Z-7)
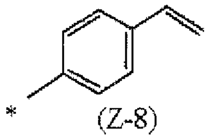
(Z-8)
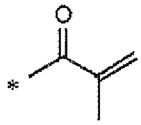
(Z-9)
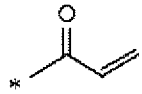
(Z-10)

* represents a connecting site to the connecting group.

Of the examples for Z above, (Z-1) to (Z-5) are preferred, (Z-1) to (Z-3) are more preferred, and (Z-1) and (Z-2) are most preferred. Further, in these cases, X is more preferably -C(=O)-O-.

The crosslinkable group can be introduced into the specific polymer compound by a polymer reaction or copolymerization. For example, a reaction between an acrylic polymer having a carboxyl group in its side chain and glycidyl methacrylate, a reaction between a polymer having an epoxy group and a carboxylic acid containing an ethylenically unsaturated group, for example, methacrylic acid, or a reaction between an isocyanate having a polymerizable group and an alcohol is utilized.

In the polymer having the crosslinkable group, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group in the specific polymer compound is preferably from 0.1 to 10.0 mmol, more preferably from 5.0 to 10.0 mmol, most preferably from 6.0 to 8.0 mmol, per g of the specific polymer compound. In the range described above, good sensitivity and preservation stability are obtained.

[Other repeating unit]

In addition, a repeating unit having an oleophilic group, for example, an alkyl group, an aryl group, an aralkyl group or an alkenyl group in its side chain may be introduced into the specific polymer compound according to the invention in order to control the ink receptive property.

In order to introduce the repeating unit having an oleophilic group into the specific polymer compound, for example, a monomer having the oleophilic group in its side chain may be copolymerized using a known polymerization initiator in an appropriate solvent.

Examples of the monomer having an oleophilic group in its side chain preferably used in the invention include styrene, an alkylstyrene (for example, methylstyrene, ethylstyrene or hexylstyrene), an alkyl acrylate (for example, methyl acrylate, ethyl acrylate, n-butyl acrylate, tert-butyl acrylate, n-hexyl acrylate or benzyl acrylate) and an alkyl methacrylate (for example, methyl methacrylate, ethyl methacrylate, n-butyl methacrylate, tert-butyl methacrylate, n-hexyl methacrylate or benzyl methacrylate).

Specific examples of the specific polymer compound preferably used in the invention are set forth in the tables shown below. The symbols used in the tables indicate the repeating units shown below, respectively.

<Repeating unit having hydrocarbon group containing an alicyclic condensed ring structure in its side chain>

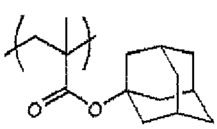
(U-1)
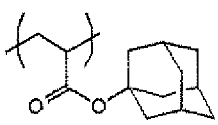
(U-2)
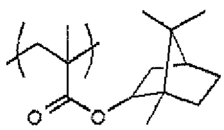
(U-3)

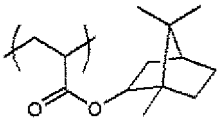

(U-4)

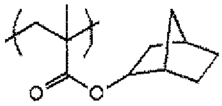

(U-5)

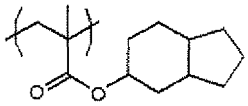

(U-6)

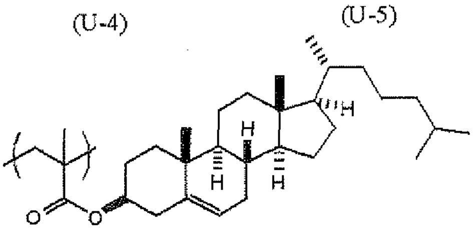

(U-7)

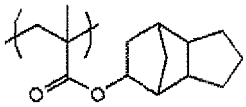

(U-8)

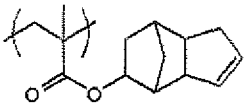

(U-9)

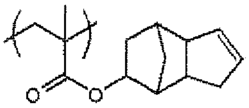

(U-10)

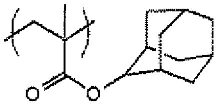

(U-11)

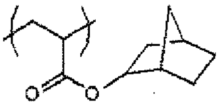

(U-12)

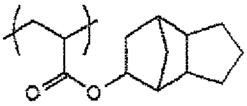

(U-13)

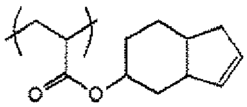

(U-14)

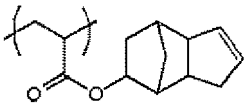

(U-15)

<Repeating unit having hydrophilic group in its side chain>

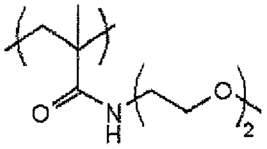
(V-1)

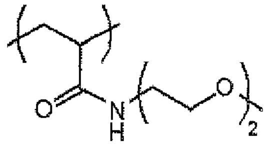
(V-2)

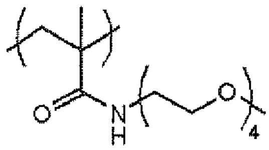
(V-3)

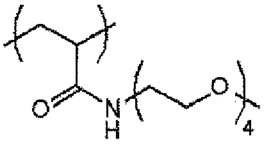
(V-4)

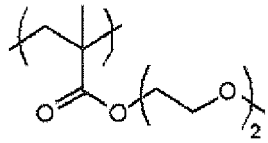
(V-5)

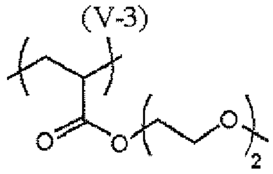
(V-6)

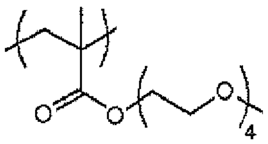
(V-7)

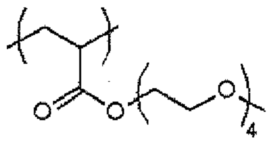
(V-8)

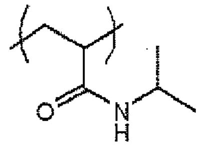
(V-9)

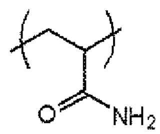
(V-10)

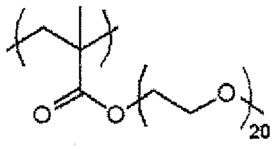
(V-11)

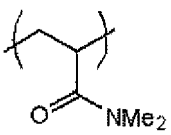
(V-12)

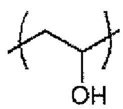
(V-13)

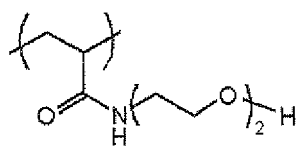
(V-14)

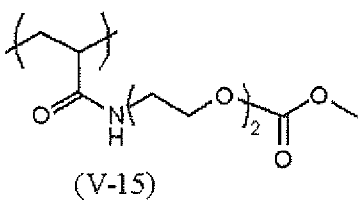
(V-15)

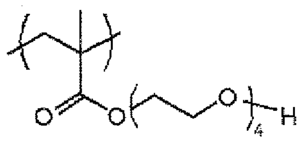
(V-16)

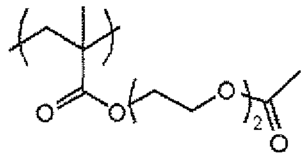
(V-17)

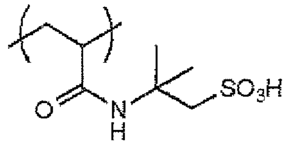
(V-18)

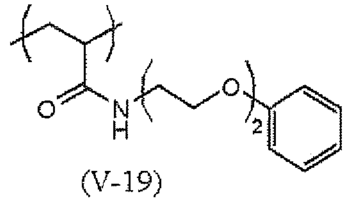
(V-19)

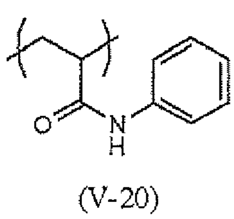
(V-20)

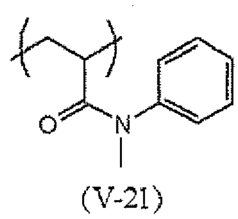
(V-21)

<Repeating unit having cyano group in its side chain>

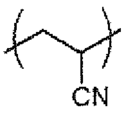
(W-1)

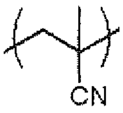
(W-2)

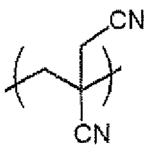
(W-3)

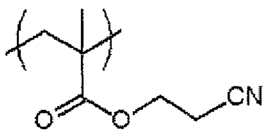
(W-4)

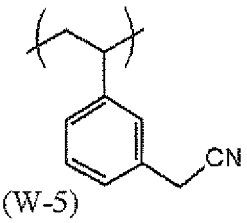
(W-5)

<Repeating unit having ethylenically unsaturated bond in its side chain>

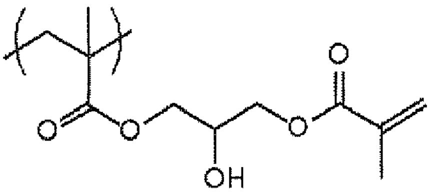
(X-1)

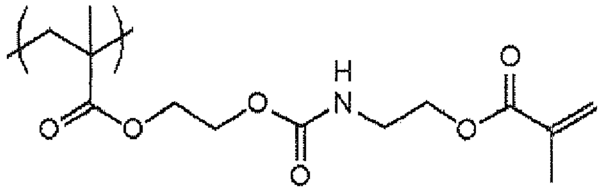
(X-2)

<Other repeating unit>

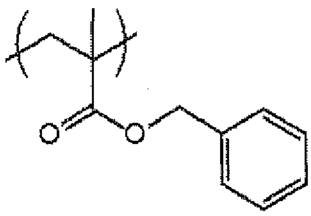
(Y-1)

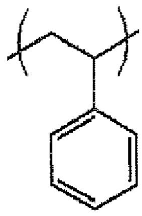
(Y-2)

TABLE 1: Specific Examples 1 of Specific Polymer Compound

| (The numeral showing a content of repeating unit is indicated by percent by mole) | | | | | | | | | | | |
|---|---|---|---|---|---|---|---|---|---|---|---|
| Specific Polymer Compound | Repeating Unit Having Condensed Ring Structure | | | | Repeating Unit Having Hydrophilic Group | | | | Repeating Unit Having Cyano Group | | Mw |
| | U-1 | U-2 | U-3 | U-4 | V-1 | V-2 | V-3 | V-4 | W-1 | W-2 | |
| E-1 | 10 | | | | 25 | | | | 65 | | 70,000 |
| E-2 | 10 | | | | | 25 | | | 65 | | 70,000 |

(continued)

| (The numeral showing a content of repeating unit is indicated by percent by mole) | | | | | | | | | | | |
|---|---|---|---|---|---|---|---|---|---|---|---|
| Specific Polymer Compound | Repeating Unit Having Condensed Ring Structure | | | | Repeating Unit Having Hydrophilic Group | | | | Repeating Unit Having Cyano Group | | Mw |
| | U-1 | U-2 | U-3 | U-4 | V-1 | V-2 | V-3 | V-4 | W-1 | W-2 | |
| E-3 | 10 | | | | | | 25 | | 65 | | 70,000 |
| E-4 | 10 | | | | | | | 25 | 65 | | 70,000 |
| E-5 | | 10 | | | 25 | | | | 65 | | 60,000 |
| E-6 | | 10 | | | | 25 | | | 65 | | 60,000 |
| E-7 | | 10 | | | | | 25 | | 65 | | 60,000 |
| E-8 | | 10 | | | | | | 25 | 65 | | 60,000 |
| E-9 | | | 10 | | 25 | | | | 65 | | 70,000 |
| E-10 | | | 10 | | | 25 | | | 65 | | 70,000 |
| E-11 | | | 10 | | | | 25 | | 65 | | 70,000 |
| E-12 | | | 10 | | | | | 25 | 65 | | 70,000 |
| E-13 | | | | 10 | 25 | | | | 65 | | 60,000 |
| E-14 | | | | 10 | | 25 | | | 65 | | 60,000 |
| E-15 | | | | 10 | | | 25 | | 65 | | 60,000 |
| E-16 | | | | 10 | | | | 25 | 65 | | 60,000 |
| E-17 | 10 | | | | 25 | | | | | 65 | 70,000 |
| E-18 | | 10 | | | | | 25 | | | 65 | 60,000 |
| E-19 | | | 10 | | 25 | | | | | 65 | 70,000 |
| E-20 | | | | 10 | | | 25 | | | 65 | 60,000 |

TABLE 2: Specific Examples 2 of Specific Polymer Compound

| (The numeral showing a content of repeating unit is indicated by percent by mole) | | | | | | | | | | | |
|---|---|---|---|---|---|---|---|---|---|---|---|
| Specific Polymer Compound | Repeating Unit Having Condensed Ring Structure | | | | | | | | Repeating Unit Having Hydrophilic Group | Repeating Unit Having Cyano Group | Mw |
| | U-5 | U-6 | U-7 | U-8 | U-9 | U-10 | U-11 | U-12 | V-1 | W-1 | |
| E-21 | 10 | | | | | | | | 25 | 65 | 70,000 |
| E-22 | | 10 | | | | | | | 25 | 65 | 70,000 |
| E-23 | | | 10 | | | | | | 25 | 65 | 70,000 |
| E-24 | | | | 10 | | | | | 25 | 65 | 70,000 |
| E-25 | | | | | 10 | | | | 25 | 65 | 70,000 |
| E-26 | | | | | | 10 | | | 25 | 65 | 70,000 |
| E-54 | | | | | | | 10 | | 25 | 65 | 70,000 |
| E-63 | | | | | | | | 10 | 25 | 65 | 70,000 |

TABLE 3: Specific Examples 3 of Specific Polymer Compound

(The numeral showing a content of repeating unit is indicated by percent by mole)

| Specific Polymer Compound | Repeating Unit Having Condensed Ring Structure | | | | Repeating Unit Having Hydrophilic Group | | | | | | | | | | | Repeating Unit Having Cyano Group | Mw |
|---|---|---|---|---|---|---|---|---|---|---|---|---|---|---|---|---|---|
| | U-1 | U-2 | U-3 | U-4 | V-5 | V-6 | V-7 | V-8 | V-9 | V-10 | V-11 | | V-12 | V-13 | V-14 | W-1 | |
| E-27 | 10 | | | | 25 | | | | | | | | | | | 65 | 70,000 |
| E-28 | | 10 | | | 25 | | | | | | | | | | | 65 | 60,000 |
| E-64 | | | 10 | | 25 | | | | | | | | | | | 65 | 70,000 |
| E-29 | | | 10 | | | 25 | | | | | | | | | | 65 | 70,000 |
| E-30 | | | | 10 | | 25 | | | | | | | | | | 65 | 60,000 |
| E-31 | 10 | | | | | | 25 | | | | | | | | | 65 | 70,000 |
| E-32 | | 10 | | | | | 25 | | | | | | | | | 65 | 60,000 |
| E-33 | | | 10 | | | | | 25 | | | | | | | | 65 | 70,000 |
| E-34 | | | | 10 | | | | 25 | | | | | | | | 65 | 60,000 |
| E-66 | | | 10 | | | | | | 25 | | | | | | | 65 | 70,000 |
| E-36 | | | 10 | | | | | | | 25 | | | | | | 65 | 70,000 |
| E-37 | 10 | | | | | | | | | | 25 | | | | | 65 | 70,000 |
| E-38 | | | 10 | | | | | | | | 25 | | | | | 65 | 70,000 |
| E-65 | | | 10 | | | | | | | | | | 25 | | | 65 | 70,000 |
| E-55 | 10 | | | | | | | | | | | | | | 25 | 65 | 70,000 |

| | U-1 | U-2 | U-3 | U-4 | V-15 | V-16 | ’ V-17 | V-18 | V-19 | V-20 | V-21 | W-1 | Mw |
|---|---|---|---|---|---|---|---|---|---|---|---|---|---|
| E-56 | | | 10 | | 25 | | | | | | | 65 | 70,000 |
| E-57 | 10 | | | | | 25 | | | | | | 65 | 70,000 |
| E-58 | | | 10 | | | | 25 | | | | | 65 | 70,000 |
| E-60 | | | 10 | | | | | | 25 | | | 65 | 70,000 |

(continued)

| (The numeral showing a content of repeating unit is indicated by percent by mole) | | | | | | | | | | | | | | | | | |
|---|---|---|---|---|---|---|---|---|---|---|---|---|---|---|---|---|---|
| Specific Polymer Compound | Repeating Unit Having Condensed Ring Structure | | | | Repeating Unit Having Hydrophilic Group | | | | | | | | | | | Repeating Unit Having Cyano Group | Mw |
| | U-1 | U-2 | U-3 | U-4 | V-5 | V-6 | V-7 | V-8 | V-9 | V-10 | V-11 | | V-12 | V-13 | V-14 | W-1 | |
| E-62 | | | 10 | | | | | | | | | | | | 25 | 65 | 70,000 |

TABLE 4: Specific Examples 4 of Specific Polymer Compound

| (The numeral showing a content of repeating unit is indicated by percent by mole) | | | | | | | | |
|---|---|---|---|---|---|---|---|---|
| Specific Polymer Compound | Repeating Unit Having Condensed Ring Structure | | Repeating Unit Having Hydrophilic Group | | Repeating Unit Having Cyano Group | | | Mw |
| | U-1 | U-3 | V-1 | V-3 | W-3 | W-4 | W-5 | |
| E-41 | 10 | | 25 | | 65 | | | 70,000 |
| E-42 | | 10 | | 25 | | 65 | | 70,000 |
| E-43 | 10 | | 25 | | | | 65 | 70,000 |

TABLE 5: Specific Examples 5 of Specific Polymer Compound

| (The numeral showing a content of repeating unit is indicated by percent by more) | | | | | | | | | |
|---|---|---|---|---|---|---|---|---|---|
| Specific Polymer Compound | Repeating Unit Having Condensed Ring Structure | | Repeating Unit Having Hydrophilic Group | | Repeating Unit Having Cyano Group | Repeating Unit Having Crosslinkable Group | | Other Repeating Unit | | Mw |
| | U-1 | U-3 | V-1 | V-3 | W-1 | X-1 | X-2 | Y-1 | Y-2 | |
| E-44 | 10 | | 20 | | 60 | 10 | | | | 70,000 |
| E-45 | 10 | | | 20 | 60 | 10 | | | | 70,000 |
| E-46 | 10 | | 20 | | 60 | | 10 | | | 70,000 |
| E-47 | 10 | | | 20 | 60 | | 10 | | | 70,000 |
| E-48 | | 10 | 20 | | 60 | 10 | | | | 70,000 |
| E-49 | | 10 | | 20 | 60 | 10 | | | | 70,000 |
| E-50 | | 10 | 20 | | 60 | | 10 | | | 70,000 |
| E-51 | | 10 | | 20 | 60 | | 10 | | | 70,000 |
| E-52 | 10 | | 20 | | 60 | | | 10 | | 70,000 |
| E-53 | | 10 | | 20 | 60 | | | | 10 | 70,000 |

TABLE 6: Specific Examples 6 of Specific Polymer Compound

| (The numeral showing a content of repeating unit is indicated by percent by mole) | | | | |
|---|---|---|---|---|
| Specific Polymer Compound | Repeating Unit Having Condensed Ring Structure | Repeating Unit Having Hydrophilic Group | Repeating Unit Having Cyano Group | Mw |
| | U-1 | V-1 | W-1 | |
| F-1 | 5 | 20 | 75 | 70,000 |
| F-2 | 10 | 10 | 80 | 70,000 |
| F-3 | 10 | 20 | 70 | 70,000 |
| F-4 | 15 | 20 | 65 | 70,000 |
| F-5 | 10 | 30 | 60 | 70,000 |
| F-6 | 10 | 50 | 40 | 70,000 |

(continued)

| (The numeral showing a content of repeating unit is indicated by percent by mole) | | | | |
|---|---|---|---|---|
| Specific Polymer Compound | Repeating Unit Having Condensed Ring Structure | Repeating Unit Having Hydrophilic Group | Repeating Unit Having Cyano Group | Mw |
| | U-1 | V-1 | W-1 | |
| F-7 | 20 | 20 | 60 | 70,000 |
| F-8 | 30 | 20 | 50 | 70,000 |
| F-9 | 40 | 20 | 40 | 70,000 |

TABLE 7: Specific Examples 7 of Specific Polymer Compound

| (The numeral showing a content of repeating unit is indicated by percent by mole) | | | | |
|---|---|---|---|---|
| Specific Polymer Compound | Repeating Unit Having Condensed Ring Structure | Repeating Unit Having Hydrophilic Group | repeating Unit Having Cyano Group | Mw |
| | U-3 | V-1 | W-1 | |
| F-101 | 5 | 20 | 75 | 70,000 |
| F-102 | 10 | 10 | 80 | 70,000 |
| F-103 | 10 | 20 | 70 | 70,000 |
| F-104 | 15 | 20 | 65 | 70,000 |
| F-105 | 10 | 30 | 60 | 70,000 |
| F-106 | 10 | 50 | 40 | 70,000 |
| F-107 | 20 | 20 | 60 | 70,000 |
| F-108 | 30 | 20 | 50 | 70,000 |
| F-109 | 40 | 20 | 40 | 70,000 |

The weight average molecular weight (Mw) of the specific polymer compound according o the invention is preferably from 2,000 to 300,000, more preferably from 5,000 to 300,000, and still preferably from 10,000 to 300,000.

According to the invention, a hydrophilic polymer, for example, polyacrylic acid or polyvinyl alcohol described in JP-A-2008-195018 may be used together with the specific polymer compound, if desired.

The content of the specific polymer compound (binder polymer) is preferably from 5 to 90% by weight, more preferably from 5 to 80% by weight, still more preferably from 10 to 70% by weight, based on the total solid content of the image-recording layer.

(B) Organic polymer particle

According to the invention, an organic polymer particle is used in order to improve the on-press development property. The organic polymer particle for use in the invention is a particle capable of converting the image-recording layer to hydrophobic state due to fusion or reaction between polymer particles when heat is applied and is also referred to as a hydrophobilizing precursor. The organic polymer particle is preferably at least one particle selected from hydrophobic thermoplastic polymer particle, thermo-reactive polymer particle, microcapsule having a hydrophobic compound encapsulated and microgel (crosslinked polymer particle). Above all, polymer particle having a polymerizable group and microgel are preferred.

As the hydrophobic thermoplastic polymer particle, hydrophobic thermoplastic polymer particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer particle include a homopolymer or copolymer of a monomer, for example, ethylene, styrene, vinyl chloride, methyl acrylate, ethyl acrylate, methyl methacrylate, ethyl

methacrylate, vinylidene chloride, acrylonitrile, methacrylonitrile, vinyl carbazole or an acrylate or methacrylate having a polyalkylene structure or polyalkylene oxide structure, and a mixture thereof. Above all, polystyrene, a copolymer containing styrene, acrylonitrile or methacrylonitrile and polymethyl methacrylate are more preferred.

The average particle size of the hydrophobic thermoplastic polymer particle for use in the invention is preferably from 0.01 to 2.0 μm.

The thermo-reactive polymer particle for use in the invention includes a polymer particle having a thermo-reactive group and forms a hydrophobilized region by crosslinkage due to thermal reaction and change in the functional group involved therein.

As the thermo-reactive group of the polymer particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group performing an addition reaction or a blocked form thereof, an epoxy group, a vinyloxy group and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

As the microcapsule for use in the invention, microcapsules having all or part of the constituting components of the image-recording layer encapsulated as described, for example, in JP-A-2001-277740 and JP-A-2001-277742 are exemplified. The constituting components of the image-recording layer may be present outside the microcapsules. It is a more preferred embodiment of the image-recording layer containing microcapsules that the hydrophobic constituting components are encapsulated in microcapsules and the hydrophilic components are present outside the microcapsules.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the radical polymerizable compound (E) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.

The content of the polymer particle is preferably in a range from 5 to 90% by weight based on the total solid content of the image-recording layer.

(C) Radical generator

The radical generator (C) for use in the invention is a compound which initiates or accelerates polymerization of the radical polymerizable compound (E). The radical generator for use in the invention is preferably a radical polymerization initiator and includes, for example, known thermal polymerization initiators, compounds containing a bond having small bond dissociation energy and photopolymerization initiators.

The radical polymerization initiators in the invention include, for example, (a) organic halides, (b) carbonyl compounds, (c) azo compounds, (d) organic peroxides, (e) metallocene compounds, (f) azido compounds, (g) hexaarylbiimidazole compounds, (h) organic borate compounds, (i) disulfone compounds, (j) oxime ester compounds and (k) onium salt compounds.

As the organic halides (a), compounds described in Paragraph Nos. [0022] to [0023] of JP-A-2008-195018 are preferred.

As the carbonyl compounds (b), compounds described in Paragraph No. [0024] of JP-A-2008-195018 are preferred.

As the azo compounds (c), for example, azo compounds described in JP-A-8-108621 are used.

As the organic peroxides (d), for example, compounds described in Paragraph No. [0025] of JP-A-2008-195018 are preferred.

As the metallocene compounds (e), for example, compounds described in Paragraph No. [0026] of J-P-A-2008-195018 are preferred.

As the azido compounds (f), compound, for example, 2,6-bis(4-azidobenzylidene)-4-methylcyclohexanone is exemplified.

As the hexaarylbiimidazole compounds (g), for example, compounds described in Paragraph No. [0027] of JP-A-2008-195018 are preferred.

As the organic borate compounds (h), for example, compounds described in Paragraph No. [0028] of JP-A-2008-195018 are preferred.

As the disulfone compounds (i), for example, compounds described in JP-A-61-166544 are exemplified.

As the oxime ester compounds (j), for example, compounds described in Paragraph Nos. [0028] to [0030] of JP-A-2008-195018 are preferred.

As the onium salt compounds (k), onium salts, for example, diazonium salts described in S. I. Schlesinger, Photogr. Sci. Eng., 18, 387 (1974) and T. S. Bal et al., Polymer. 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J.V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827, German Patents 2,904,626, 3,604,580 and 3,604,581, selenonium salts described in J.V. Crivello et al., J. Polymer Sci., Polymer Chem. Ed., 17, 1047 (1979), arsonium salts described in C.S. Wen et al., Teh, Proc. Conf. Rad. Curing ASIA, p. 478, Tokyo, Oct. (1988), and azinium salts described in JP-A-2008-195018 are exemplified.

Of the radical polymerization initiators, the onium salts, particularly, the iodonium salts, sulfonium salts and azinium salts are preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxypbenyl-4-(2-methylpropyl)phenyhodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodoniurn tetrafluoroborate, 4-octyloxyphenyl-2,4,6-trimethoxyphenyliodonium 1-perfluarobutanesulfanate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium3,5-bis(methoxycarbanyl)benzenesulfonate and tris(4-chlorophenyl)sulfonium hexafluorophosphate,

Examples of the azinium salt include 1-cyclohexylmethyloxypyridinium hexafluorophosphate, 1-cyclohexylaxy-4-phenylpyridinimn hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridimum hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical generator can be added to the image-recording layer preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

(D) Infrared absorbing agent

The infrared absorbing agent has a function of converting the infrared ray absorbed to heat and a function of being excited by the infrared ray to perform electron transfer and/or energy transfer to the radical generator described above. The infrared absorbing agent for use in the invention is a dye having an absorption maximum in a wavelength range from 760 to 1,200 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by formula (a) shown below is exemplified.

Formula (a):

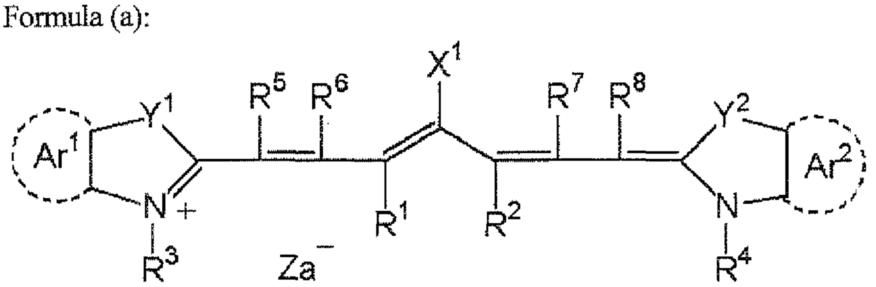

In formula (a), $X^1$ represents a hydrogen atom, a halogen atom, $-N(R^9)(R^{10})$, $X^2-L^1$ or a group shown below. $R^9$ and $R^{10}$, which may be the same or different, each represents an aryl group having from 6 to 10 carbon atoms, which may have a substituent, an alkyl group having from 1 to 8 carbon atoms, which may have a substituent or a hydrogen atom, or $R^9$ and $R^{10}$ may be combined with each other to form a ring. Above all, a phenyl group is preferred ($-NPh_2$). $X^2$ represents an oxygen atom or a sulfur atom, $L^1$ represents a hydrocarbon group having from 1 to 12 carbon atoms, a hetero aryl group or a hydrocarbon group having from 1 to 12 carbon atoms and containing a hetero atom. The hetero atom used herein indicates a nitrogen atom, a sulfur atom, an oxygen atom, a halogen atom and a selenium atom. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

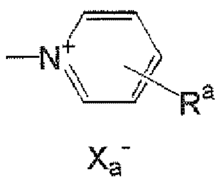

$R^1$ and $R^2$ each independently represents a hydrocarbon group having from 1 to 12 carbon atoms. In view of the preservation stability of a coating solution for image-recording layer, it is preferred that $R^1$ and $R^2$ each represent a hydrocarbon group having two or more carbon atoms. Also, $R^1$ and $R^2$ may be combined with each other to form a ring and in case of forming the ring, to form a 5-membered ring or 6-membered ring is particularly preferred.

$Ar^1$ and $Ar^2$, which may be the same or different, each represents an aryl group which may have a substituent. Preferable examples of the aryl group include a benzene ring group and a naphthalene ring group. Also, preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion.

Specific examples of the cyanine dye represented by formula (a), which can be preferably used, include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and most preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dyes may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the infrared absorbing dye in the image-recording layer according to the invention is preferably

from 0.1 to 10.0% by weight, more preferably from 0.5 to 5.0% by weight, based on the total solid content of the image-recording layer.

(E) Radical polymerizable compound

The radical polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The radical polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof Preferably, esters of an unsaturated carboxylic acid with a polyhydric alcohol compound and amides of an unsaturated carboxylic acid with a polyvalent amine compound are used, An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyelhoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708 (the term "JP-B" as used herein means an "examined Japanese patent publication").

$$CH2{=}C(R4)COOCH_2CH(R_5)OH \qquad (A)$$

wherein $R_4$ and $R_5$ each independently represents H or $CH_3$.

Also, urethane acrylates described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris (acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the radical polymerizable compound, for example, selection of the structure, individual or combination use or the amount added, can be appropriately determined in accordance with the characteristic design of the final lithographic printing plate precursor. The radical polymerizable compound is used preferably in a

range from 5 to 75% by weight, more preferably in a range from 25 to 70% by weight, particularly preferably in a range from 30 to 60% by weight, based on the total solid content of the image-recording layer.

(F) Other components

The image-recording layer according to the invention may further contain other components, if desired.

(1) Hydrophilic low molecular weight compound

The image-recording layer according to the invention may contain a hydrophilic low molecular weight compound in order to improve the on-press development property without accompanying the decrease in the printing durability.
The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyol compound, e.g., glycerine, pentaerythritol or tris(2-hydroxyethyl) isocyanurate, an organic amine compound, e.g., triethanol amine, diethanol amine or monoethanol amine, or a salt thereof, an organic sulfonic acid compound, e.g., an alkyl sulfonic acid, toluene sulfonic acid or benzene sulfonic acid, or a salt thereof, an organic sulfamic acid compound, e.g., an alkyl sulfamic acid, or a salt thereof, an organic sulfuric acid compound, e.g., an alkyl sulfuric acid or an alkyl ether sulfuric acid, or a salt thereof, an organic phosphonic acid compound, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine compound.
According to the invention, it is preferred that at least one compound selected from a polyol compound, an organic sulfate compound, an organic sulfonate compound and a betaine compound is incorporated.
Specific examples of the organic sulfonate compound include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtylfirisulfonate, and compounds described in Paragraph Nos. [0026] to [0031] of JP-A-2007-276454 and Paragraph Nos. [0020] to [0047] of JP-A-2009-154525. The salt may also be potassium salt or lithium salt.
The organic sulfate compound includes a sulfate of alkyl, alkenyl, alkynyl, aryl or heterocyclic monoether of polyethylene oxide. The number of unit of ethylene oxide is preferably from 1 to 4. The salt is preferably a sodium salt, a potassium salt or a lithium salt. Specific examples thereof include compounds described in Paragraph Nos. [0034] to [0038] of JP-A-2007-276454.
As the betaine compound, a compound wherein a number of carbon atoms included in a hydrocarbon substituent on the nitrogen atom is from 1 to 5 is preferable. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.
Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptive-property and printing durability of the image-recording layer can be preferably maintained.
The amount of the hydrophilic low molecular weight compound added to the image-recording layer is preferably from 0.5 to 20% by weight, more preferably from 1 to 15% by weight, still more preferably from 2 to 10% by weight, based on the total solid content of the image-recording layer. In the range described above, good on-press development property and printing durability are obtained.
The hydrophilic low molecular weight compounds may be used individually or as a mixture of two or more thereof.

(2) Oil-sensitizing agent

In order to improve the ink-receptive property, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into a protective layer, the oil-sensitizing agent functions as a surface covering agent of the inorganic stratiform compound and prevents deterioration of the ink-receptive property during printing due to the inorganic stratiform compound.
As preferable examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include polymers described in Paragraph Nos. [0089] to [0105] of JP-A-2009-208458.

As to the ammonium group-containing polymer, its reduced specific viscosity value (unit: ml/g) determined according to the measuring method described below is preferably from 5 to 120, more preferably from 10 to 110, particularly preferably from 15 to 100. When the reduced specific viscosity value described above is calculated in terms of weight average molecular weight, from 10,000 to 150,000 is preferred, from 17,000 to 140,000 is more preferred, and 20,000 to 130,000 is particularly preferred.

<Measuring method of reduced specific viscosity>

In a 20 ml measuring flask was weighed 3.33 g of a 30% by weight polymer solution (1 g as a solid content) and the measuring flask was filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity was calculated according to the formula shown below.

$$\text{Reduced specific viscosity (ml/g)} = \frac{\dfrac{\text{Period for running down of sample solution (sec)} - \text{Period for running down of blank (sec)}}{\text{Period for running down of blank (sec)}}}{\dfrac{3.33\ (\text{g}) \times \dfrac{30}{100}}{20\ (\text{ml})}}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90, weight average molecular weight: 45,000)

(2) 2-(Trimethylammonio)ethyl methacrylate hexafluorophosphate /3,6-dioxaheptyl methacrylate copolymer (molar ratio: 20/80, weight average molecular weight: 60,000)

(3) 2-(Ethyldmiethylammonio)ethyl methacrylate p-toluenesulfonate/hexyl methacrylate copolymer (molar ratio: 30/70, weight average molecular weight: 45,000)

(4) 2-(Trimethylammonio)ethyl methacrylate hexafluorophosphate /2-ethylhexyl methacrylate copolymer (molar ratio: 20/80, weight average molecular weight: 60,000)

(5) 2-(Trimethylammonio)ethyl methacrylate methylsulfate/hexyl methacrylate copolymer (molar ratio: 40/60, weight average molecular weight: 70,000)

(6) 2-(Butyldimethylammonio)ethyl methacrylate hexafluorophosphate/3,6-dioxaheptyl methacrylate copolymer (molar ratio: 25/75, weight average molecular weight: 65,000)

(7) 2-(Butyldimethylammonio)ethyl acrylate hexafluorophosphate/3,6-dioxaheptyl methacrylate copolymer (molar

ratio: 20/80, weight average molecular weight: 65,000)

(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, weight average molecular weight: 75,000)

(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, weight average molecular weight: 65,000)

The content of the oil-sensitizing agent is preferably from 0.01 to 30.0% by weight, more preferably from 0.1 to 15.0% by weight, still more preferably from 1 to 5% by weight, based on the total solid content of the image-recording layer.

(3) Others

Other components, for example, a surfactant, a coloring agent, a print-out agent, a polymerization inhibitor, a higher fatty acid derivative, a plasticizer, an inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

(G) Formation of image-recording layer

The image-recording layer according to the invention is formed by dispersing or dissolving each of the necessary constituting components described above in a solvent to prepare a coating solution and coating the solution on a support by a known method, for example, bar coater coating and drying as described in Paragraph Nos. [0142] to [0143] of JP-A-2008-195018. The coating amount (solid content) of the image-recording layer formed on a support after coating and drying may be varied according to the intended purpose but is in general preferably from 0.3 to 3.0 $g/m^2$. In the range described above, good sensitivity and good film property of the image-recording layer can be obtained.

(Undercoat layer)

In the lithographic printing plate precursor according to the invention, an undercoat layer (also referred to as an intermediate layer) is preferably provided between the image-recording layer and the support. The undercoat layer strengthens adhesion between the support and the image-recording layer in the exposed area and makes removal of the image-recording layer from the support easy in the unexposed area, thereby contributing improvement in the developing property without accompanying degradation of the printing durability. Further, it is advantageous that in the case of infrared laser exposure, since the undercoat layer acts as a heat insulating layer, decrease in sensitivity due to diffusion of heat generated upon the exposure into the support is prevented.

As a compound for use in the undercoat layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and also may be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used

Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for undercoat layer is preferably from

0.1 to 10.0 mmol, most preferably from 0.2 to 5.5 mmol, based on 1 g of the polymer compound.

The weight average molecular weight of the polymer compound for undercoat layer is preferably 5,000 or more, and more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to preservation of the lithographic printing plate precursor.

The undercoat layer is coated according to a known method. The coating amount (solid content) of the undercoat layer is preferably from 0.1 to 100 mg/$m^2$, and more preferably from 1 to 30 mg/$m^2$.

(Support)

As the support for use in the lithographic printing plate precursor according to the invention, a known support is used. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu$m.

The support may have a backcoat layer containing an organic polymer compound described in JP-A-5-45885 or an alkoxy compound of silicon described in JP-A-6-35174, provided on the back surface thereof, if desired.

(Protective layer)

In the lithographic printing plate precursor according to the invention, it is preferred to provide a protective layer (overcoat layer) on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxylic acid group or a sulfonic acid group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or an inorganic particle for controlling a surface slipping property. The oil-sensitizing agent described with respect to the image-recording layer may also be incorporated into the protective layer.

The protective layer is coated according to a known method. The coating amount of the protective layer is preferably in a range of 0.01 to 10 g/$m^2$, more preferably in a range of 0.02 to 3 g/$m^2$, most preferably in a range of 0.02 to 1 g/$m^2$, in terms of the coating amount after drying.

[Plate making method]

Plate making of the lithographic printing plate precursor according to the invention is preferably performed by an on-press development method. The on-press development method includes a step in which the lithographic printing plate precursor is imagewise exposed and a printing step in which at least any one of oily ink and an aqueous component is supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic

printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

The plate making method is described in more detail below.

As the light source used for the image exposure in the invention, a laser is preferable. The laser for use in the invention is not particularly restricted and preferably includes, for example, a solid laser or semiconductor laser emitting an infrared ray having a wavelength of 760 to 1,200 nm.

With respect to the infrared ray laser, the output is preferably 100 mW or more, the exposure time per pixel is preferably within 20 microseconds, and the irradiation energy is preferably from 10 to 300 $mJ/cm^2$. With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres onto the revealed hydrophilic surface and the printing ink adheres onto the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

## EXAMPLES

The present invention will be described in more detail with reference to the following examples, but the invention should not be construed as being limited thereto. With respect to the polymer compounds used in the examples, a molecular weight means a weight average molecular weight (Mw) and a ratio of repeating unit is indicated in mole percent, unless otherwise particularly defined.

### Examples 1 to 21 and Comparative Examples 1 to 2

[Preparation 1 of Lithographic printing plate precursor]

An aluminum plate having a thickness of 0.24 mm was degreased with an aqueous sodium hydroxide solution and subjected to an electrolysis graining treatment in an aqueous 2.0% by weight hydrochloric acid solution to obtain a grained aluminum plate having a centerline average roughness (Ra) of 0.6 μm. The aluminum plate was then subjected to an anodizing treatment in a 20% by weight sulfuric acid bath at a current density of $2A/dm^2$ to form an anodic oxide film of 2.7 $g/m^2$, followed by washing with water and drying, thereby preparing an aluminum support. On the aluminum support thus-prepared, a coating solution for image-recording layer shown below was coated using a bar and dried in an oven at 70°C for 60 seconds to form an image-recording layer having a thickness of 0.6 $g/m^2$, thereby preparing a lithographic printing plate precursor.

<Coating solution (1) for image-recording layer>

| | |
|---|---|
| Aqueous dispersion of organic polymer particle shown below | 20.0 g |
| Infrared absorbing agent (1) having structure shown below | 0.2 g |
| Radical generator (IRGACURE 250, produced by Ciba Specialty Chemicals, Inc.) | 0.5 g |

(continued)

| | |
|---|---|
| Binder polymer (specific polymer compound) shown in Table 8 | 0.6 g |
| Radical polymerizable compound (SR-399, produced by Sartomer Co., Inc.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 7.0 g |

The materials used in the coating solution for image-recording layer above are described below.

Infrared absorbing agent (1)

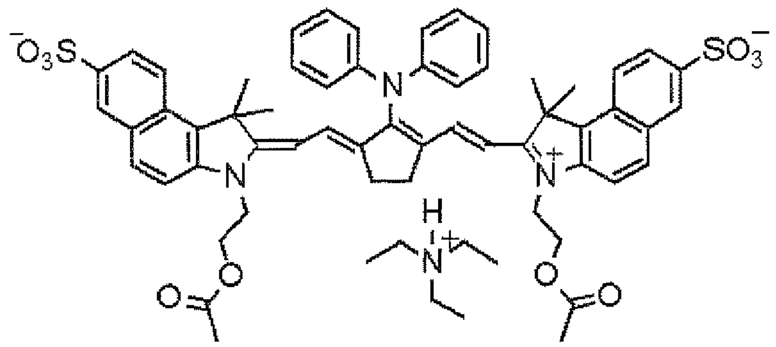

(Preparation of Aqueous dispersion of organic polymer particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average number of ethylene glycol repeating units: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the interval temperature was raised to 80°C. Thereafter, 0.5 g of 2,2-azobisisobutyronitrile was added over a period of 6 hours. At the stage after reacting for 20 hours in total, the polymerization proceeded 98% or more to obtain an aqueous dispersion of organic polymer particle of PEGMA/St/AN (10/10/80 in a weight ratio). The particle size distribution of the polymer particle had the maximum value at the particle size of 150 nm.

The particle size distribution was determined by taking an electron microphotograph of the polymer particle, measuring particle sizes of 5,000 particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

The compounds indicated using their trade names in the composition above are shown below.

IRGACURE 250: (4-Methoxyphenyl)[4-(2-methylpropyl)phenyl]iodonium hexafluorophosphate (75% by weight propylene carbonate solution)
SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution)

Synthesis of Binder polymer (Specific polymer compound)

E-1 to E-43, E-52 to E-67, F-1 to F-9, F-101 to F-109 and R-1 for Comparative Example:

The monomers were copolymerized in the ratio shown in the tables above to obtain the polyacrylonitrile type binder polymers, respectively.

E-44 to E-51 and R-2 for Comparative Example:

Acrylonitrile (60% by mole), acrylamide shown in the table above (20% by mole), 1-adamantyl methacrylate or isobornyl methacrylate (10% by mole), methacrylic acid or 2-hydroxyethyl methacrylate (10% by mole) were copolymerized in 1-methoxy-2-propernol at 70°C. To the polymer solution thus-obtained, 0.12 equivalent (to methacrylic acid) of glycidyl methacrylate and 0.01 equivalent of tetraethylammonium bromide were added in the case where the repeating unit containing a crosslinkable group was X-1, or 0.12 equivalent (to 2-hydroxyethyl methacrylate) of 2-methacryloyloxyethyl isocyanate, 0.01 equivalent of NEOSTAN U-600 (produced by Nitto Kasei Co., Ltd.) and 0.001 equivalent of 4-hydroxy-2,2,6,6,-tetramethylpiperidinoxyl were added in the case where the repeating unit containing a crosslinkable group was X-2, and heated at 45°C for 2 hours to obtain the polyacrylonitrile type binder polymers having a polymerizable group, respectively.

R-3 to R-4 for Comparative Example:

The binder polymers were synthesized according to the method described in JP-T-2009-517720.

Binder Polymers for Comparative Example

R-1

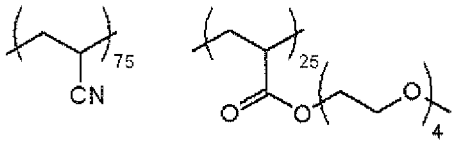

Mw 70,000

R-2

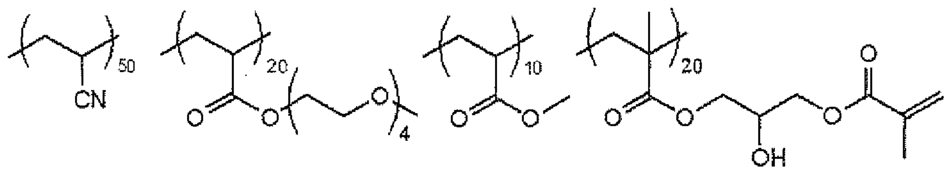

Mw 70,000

R-3

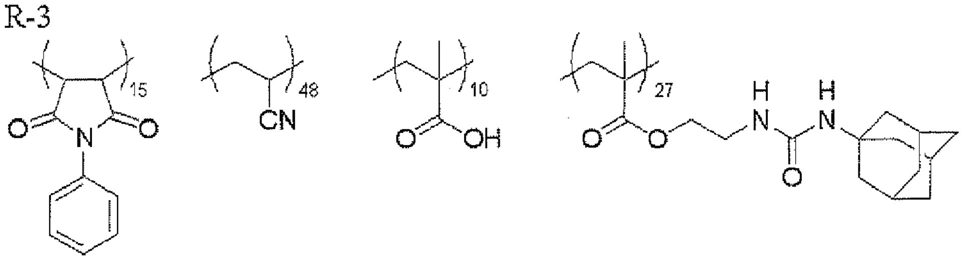

Mw 70,000

R-4

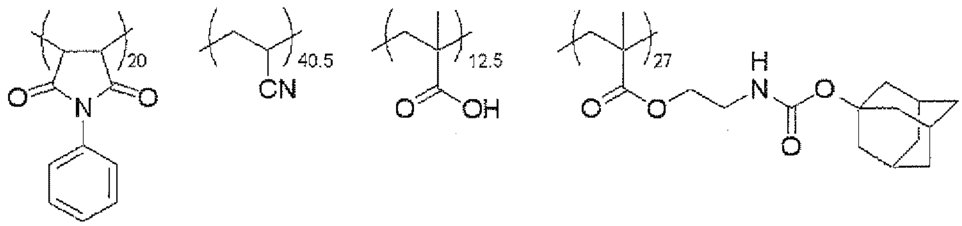

Mw 70,000

Examples 22 and Comparative Examples 3 to 5

[Preparation 2 of Lithographic printing plate precursor]

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of purnice having a median size of 25 μm, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized film of 2.5 g/m$^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then washed with water to obtain Support (2). The adhesion amount of Si was 10 mg/m$^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) so as to have a dry coating amount of 20 mg/m$^2$ to prepare a support having an undercoat layer for using the experiments described below.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

Compound (1) for undercoat layer:

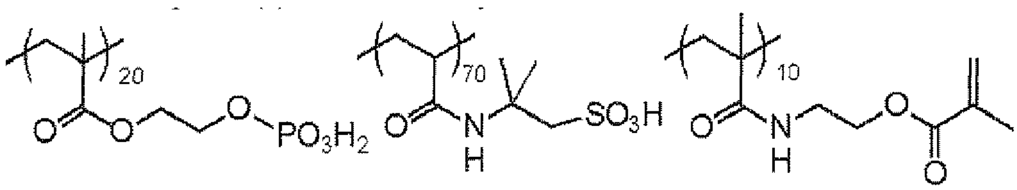

(Mw100, 000)

(3) Formation of Image-recording layer

Coating solution (2) for image-recording layer having the composition shown below was coated on the undercoat layer described above by a bar and dried in an oven at 100°C for 60 seconds to form an image-recording layer having a dry coating amount of 1.0 g/$m^2$.

Coating solution (2) for image-recording layer was prepared by mixing Photosensitive solution (1) shown below with Microgel solution (1) shown below just before the coating, followed by stirring.

<Photosensitive solution (1)>

| | |
|---|---|
| Binder polymer (specific polymer compound) shown in Table 9 | 0.240 g |
| Infrared absorbing agent (2) having structure shown below | 0.033 g |
| Radical generator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.05 g |
| Oil-sensitizing agent (phosphonium compound (1) having structure shown below) | 0.055 g |
| Oil-sensitizing agent (Benzyl dimethyl octyl ammonium $PF_6$ salt | 0.018 g |
| Oil-sensitizing agent (Ammonium group-containing polymer having structure shown below (reduced specific viscosity: 44 ml/g) | 0.035 g |
| Fluorine-based surfactant (1) having structure shown below | 0.008 g |
| 2-Butanone | 1.091 g |
| 1-Methoxy-2-propanol | 8.609 g |

<Microgel solution (1)>

| | |
|---|---|
| Microgel (1) shown below | 2.640 g |
| Distilled water | 2.425 g |

The structures of Infrared absorbing agent (2), Radical generator (1), Phosphonium compound (1), Hydrophilic

low molecular weight compound (1), Oil-sensitizing agent (ammonium group-containing polymer) and Fluorine-based surfactant (1) are shown below.

Ammonium group-containing polymer:

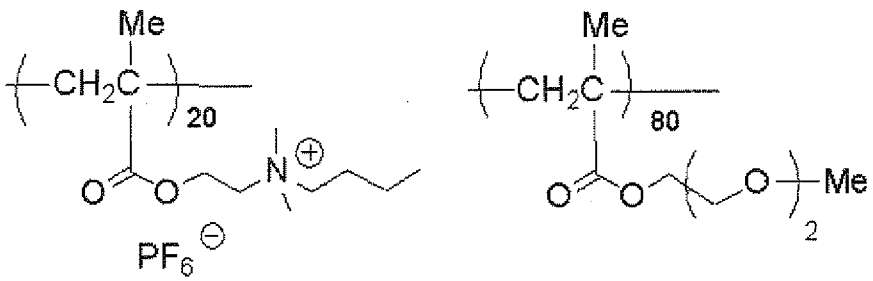

Infrared absorbing agent (2):

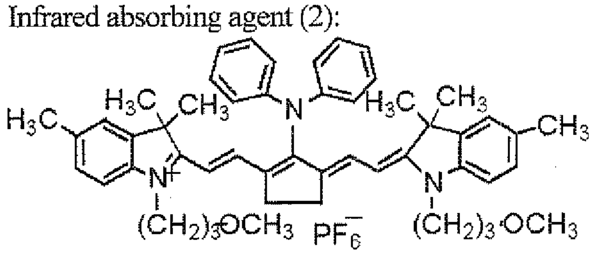

Radical generator (1):

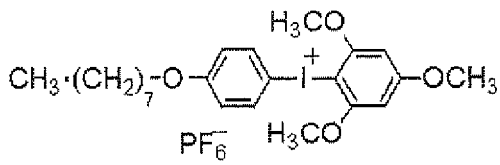

Fluorine-based surfactant (1):

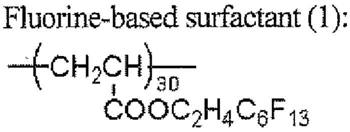

Hydrophilic low molecular weight compound (1):

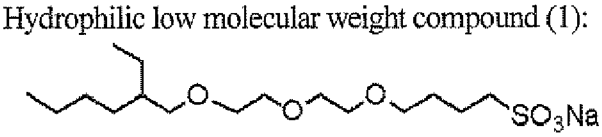

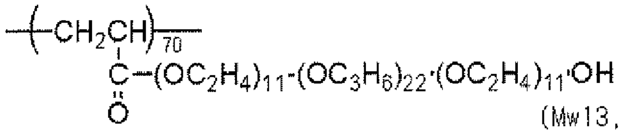

(Mw13,000)

Phosphonium compound (1):

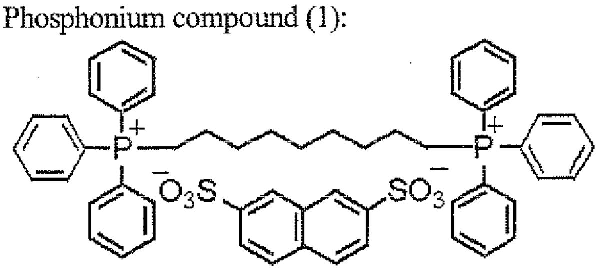

(Preparation of Microgel (1))

An oil phase component was prepared by dissolving 10 g of adduct of timethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g

of ethyl acetate. As an aqueous phase component, 40 g of a 4% by weight aqueous solution of polyvinyl alcohol (PVA-205, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid concentration of 15% by weight to prepare Microgel (1). The average particle size of Microgel (1) was measured by a light scattering method and found to be 0.2 μm.

(4) Formation of protective layer

Coating solution (1) for protective layer having the composition shown below was coated on the image-recording layer described above by a bar and dried in an oven at 120°C for 60 seconds to form a protective layer having a dry coating amount of 0.15 g/$m^2$, thereby preparing a lithographic printing plate precursor.

<Coating solution (1) for protective layer>

| | |
|---|---|
| Dispersion of inorganic stratiform compound (1) shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1 % by weight solution of surfactant (EMALEX 710, produced by Nihon Emulsion Co., Ltd.) | 0.86 g |
| Ion-exchanged water | 6.0 g |

(Preparation of Dispersion of inorganic stratiform compound (1))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm to prepare Dispersion of inorganic stratiform compound (1). The aspect ratio of the inorganic particle thus-dispersed was 100 or more.

[Evaluation of Lithographic printing plate precursor]

(1) On-press development property

Each of the lithographic printing plate precursors thus-obtained was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct printing on TOKUBISHI ART PAPER (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Tables 8 and 9.

(2) Printing durability

After performing the evaluation for the on-press development property described above, the printing was continued. As the increase in a number of printing papers, the image-recording layer was gradually abraded to cause decrease in the ink density on the printing paper. A number of the printing papers wherein a value obtained by measuring a halftone dot area rate of the 50% halftone dot of FM screen on the printing paper using a Gretag densitometer decreased

by 5% from the value measured on the 100th paper of the printing was determined to evaluate the printing durability. The results obtained are shown in Tables 8 and 9.

(3) Chemical resistance

The exposed lithographic printing plate precursor was immersed in a mixed solution of 3-methyl-3-methoxybutanol and ethanol (1:1 in volume ratio) for 30 seconds and then the degree of erosion in the image-recording layer was evaluated according to the three-level criteria described below. The results obtained are shown in Tables 8 and 9.

A: No erosion was observed at all.
B: Erosion was partially observed.
C: Image-recording layer was completely dissolved.

(4) Scratch resistance

The surface of the image area which was made by conducting the exposure and the development was scratched using a continuous loading scratch strength tester (produced by Shinto Scientific Co., Ltd.) with a sapphire stylus having a diameter of 0.1 mm under a load from 10 to 500 g. The maximum load at which the scratch was not made was determined to evaluate the scratch resistance. The results obtained are shown in Tables 8 and 9.

TABLE 8: Examples 1 to 21 and Comparative Examples 1 to 2

| | Specific Polymer Compound | Scratch Resistance (g) | Printing Durability (sheets) | On-Press Development Property (sheets) | Chemical Resistance |
|---|---|---|---|---|---|
| Example 1 | F-101 | 150 | 80,000 | 5 | A |
| Example 2 | F-102 | 250 | 75,000 | 15 | A |
| Example 3 | F-103 | 250 | 100,000 | 10 | A |
| Example 4 | F-104 | 250 | 100,000 | 15 | A |
| Example 5 | F-105 | 250 | 70,000 | 10 | A |
| Example 6 | F-106 | 250 | 45,000 | 5 | B |
| Example 7 | F-107 | 300 | 100,000 | 15 | A |
| Example 8 | F-108 | 300 | 100,000 | 20 | A |
| Example 9 | F-109 | 300 | 100,000 | 25 | B |
| Example 10 | E-65 | 200 | 100,000 | 15 | A |
| Example 11 | E-66 | 200 | 100,000 | 10 | A |
| Example 12 | E-27 | 200 | 100,000 | 10 | A |
| Example 13 | E-37 | 150 | 100,000 | 15 | A |
| Example 14 | E-48 | 300 | 150,000 | 5 | A |
| Example 15 | E-21 | 200 | 100,000 | 15 | A |
| Example 16 | E-22 | 100 | 100,000 | 15 | A |
| Example 17 | E-23 | 100 | 100,000 | 15 | A |
| Example 18 | E-24 | 150 | 100,000 | 15 | A |
| Example 19 | E-25 | 150 | 100,000 | 15 | A |
| Example 20 | E-26 | 150 | 100,000 | 15 | A |
| Example 21 | E-53 | 200 | 100,000 | 10 | A |

(continued)

| | Specific Polymer Compound | Scratch Resistance (g) | Printing Durability (sheets) | On-Press Development Property (sheets) | Chemical Resistance |
|---|---|---|---|---|---|
| Comparative Example 1 | R-1 | 30 | 30,000 | 28 | C |
| Comparative Example 2 | R-2 | 30 | 40,000 | 20 | C |

TABLE 9: Example 22 and Comparative Examples 3 to 5

| | Specific Polymer Compound | Scratch Resistance (g) | Printing Durability (sheets) | On-Press Development Property (sheets) | Chemical Resistance |
|---|---|---|---|---|---|
| Example 22 | F-102 | 250 | 75,000 | 15 | A |
| Comparative Example 3 | R-1 | 80 | 30,000 | 28 | C |
| Comparative Example 4 | R-3 | 120 | 35,000 | >500 | C |
| Comparative Example 5 | R-4 | 100 | 30,000 | > 500 | C |

As is apparent from the results shown in Tables 8 and 9, the lithographic printing plate precursor which provides good scratch resistance while maintaining the excellent printing durability, chemical resistance and on-press development property can be obtained.

## Claims

**1.** A lithographic printing plate precursor capable of undergoing on-press development, comprising:

a support; and
an image-recording layer comprising (A) a binder polymer containing a repeating unit having a hydrocarbon group containing an alicyclic condensed ring structure in a side chain, a repeating unit having at least one hydrophilic group selected from a hydroxy group, an amino group, an amido group, a sulfonic acid group and an alkyleneoxide chain in a side chain and a repeating unit having a cyano group in a side chain, (B) an organic polymer particle, (C) a radical generator, (D) an infrared absorbing agent and (E) a radical polymerizable compound,
wherein a combination of the repeating unit having a condensed ring structure in a side chain and the repeating unit having a hydrophilic group in a side chain in the binder polymer (A) is a combination selected from the following 1) to 3):

1) combination where the condensed ring structure is an adamantane skeleton and the hydrophilic group is a group represented by the following formula 3,
2) combination where the condensed ring structure is a norbornane skeleton and the hydrophilic group is at least one group selected from an amido group and a group represented by the following formula 3, and
3) combination where the condensed ring structure comprises neither the adamantane skeleton nor the norbornane skeleton and the hydrophilic group is a group selected from a hydroxy group, an amino group, an amido group, a sulfonic acid group and a group represented by the following formula 3:

Formula 3:

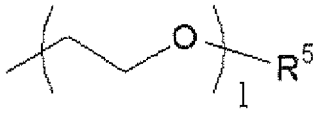

wherein, $R^5$ represents a hydrogen atom, an alkyl group, an aryl group, -C(=O)-R or -C(=O)-O-R, R represents an alkyl group, an alkenyl group, an alkynyl group or an aryl group each having 20 or less carbon atoms, and 1 represents an integer of from 2 to 90.

**2.** The lithographic printing plate precursor as claimed in claim 1, wherein the binder polymer (A) is a vinyl copolymer.

**3.** The lithographic printing plate precursor as claimed in claim 1 or 2, wherein the repeating unit having a hydrocarbon group containing an alicyclic condensed ring structure in a side chain in the binder polymer (A) is a repeating unit represented by the following formula 1:

Formula 1:

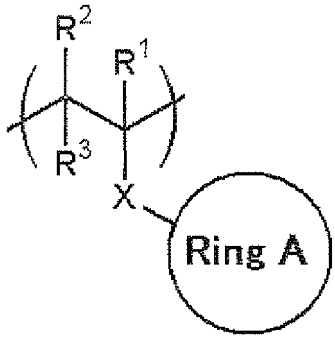

wherein, $R^1$ represents a hydrogen atom or a methyl group, $R^2$ and $R^3$ each independently represents a hydrogen atom, an alkyl group or an aryl group, X represents a single bond or a difunctional connecting group, and Ring A represents an alicyclic hydrocarbon group having a condensed ring structure containing at least one 5-membered or 6-membered ring.

**4.** The lithographic printing plate precursor as claimed in claim 3, wherein a number of carbon atoms contained in the Ring A in the formula 1 is from 7 to 25.

**5.** The lithographic printing plate precursor as claimed in claim 3 or 4, wherein X in the formula 1 is -CO-O-.

**6.** The lithographic printing plate precursor as claimed in any one of claims 3 to 5, wherein the Ring A in the formula 1 is an alicyclic hydrocarbon group selected from the following groups and the hydrophilic group is a group selected from a hydroxy group, an amino group, an amido group, a sulfonic acid group and a group represented by the formula 3:

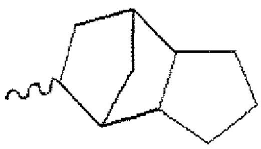 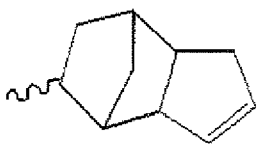 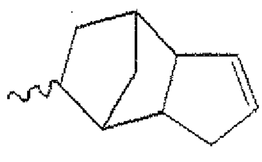 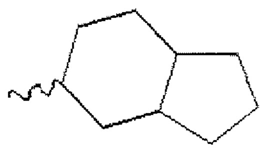

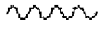 indicates a connecting position to the connecting group represented by X

**7.** The lithographic printing plate precursor as claimed in any one of claims 1 to 6, wherein the repeating unit having a hydrophilic group in a side chain in the binder polymer (A) is a repeating unit represented by the following formula 2:

Formula 2:

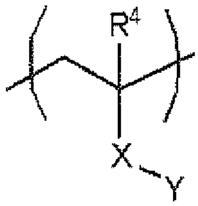

wherein $R^4$ represents a hydrogen atom or a methyl group, X represents a single bond or a difunctional connecting group, and Y represents a hydrophilic group selected from a hydroxy group, an amino group, an amido group, a sulfonic acid group and a group represented by the formula 3.

**8.** The lithographic printing plate precursor as claimed in claim 7, wherein the repeating unit having a Hydrophilic group in a side chain in the binder polymer (A) is a repeating unit represented by the following formula 4 or 5:

Formula 4:

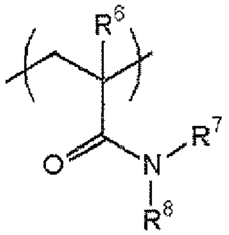

Formula 5:

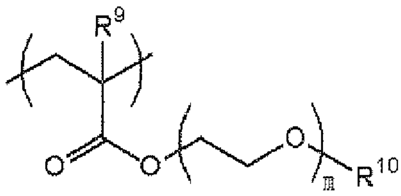

wherein $R^6$ represents a hydrogen atom or a methyl group, $R^7$ and $R^8$ each independently represents a hydrogen atom, an alkyl group, an aryl group or a group represented by the following formula 6, or $R^7$ and $R^8$ may be combined with each other to form a ring, $R^9$ represents a hydrogen atom or a methyl group, $R^{10}$ represents a hydrogen atom, an alkyl group or an aryl group, and m represents an integer of from 2 to 90:

Formula 6:

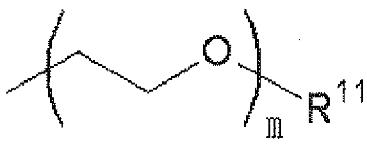

wherein $R^{11}$ represents a hydrogen atom, an alkyl group, an aryl group, -C(=O)-R or -C(=O)-O-R, R represents an alkyl group, an alkenyl group, an alkenyl group or an aryl group each having 20 or less carbon atoms, and represents an integer of from 2 to 90.

**9.** The lithographic printing plate precursor as claimed in claim 7 or 8, wherein $R^7$ in the formula 4 is a hydrogen atom or a group represented by the formula 6, and $R^8$ in the formula 4 is a hydrogen atom, an alkyl group having 12 or less carbon atoms or a group represented by the formula 6.

**10.** The lithographic printing plate precursor as claimed in claim 9, wherein $R^7$ in the formula 4 is a hydrogen atom and $R^8$ in the formula 4 is a group represented by the formula 6.

**11.** The lithographic printing plate precursor as claimed in any one of claims 1 to 10, wherein the repeating unit having a cyano group in a side chain in the binder polymer (A) is a repeating unit represented by the following formula 7:

Formula 7:

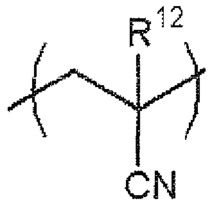

wherein $R^{12}$ represents a hydrogen atom or an alkyl group.

**12.** The lithographic printing plate precursor as claimed in any one of claims 1 to 11, wherein the binder polymer (A) comprises from 5 to 35% by mole of the repeating unit having a hydrocarbon group containing an alicyclic condensed ring structure in a side chain, from 5 to 40% by mole of the repeating unit having a hydrophilic group in a side chain and 50 to 80% by mole of the repeating unit having a cyano group in a side chain.

**13.** The lithographic printing plate precursor as claimed in any one of claims 1 to 12, wherein the binder polymer (A) is a polymer containing a repeating unit having an ethylenically unsaturated bond in a side chain.

**14.** The lithographic printing plate precursor as claimed in any one of claims 1 to 13, wherein the organic polymer particle (B) is a copolymer containing acrylonitrile or methacrylonitrile.

**15.** A plate making method of a lithographic printing plate, comprising:

exposing imagewise the lithographic printing plate precursor as claimed in any one of claims 1 to 14,
mounting the exposed lithographic printing plate precursor on a printing machine; and
supplying at least one of dampening water and ink to the mounted lithographic printing plate precursor to remove an unexposed area of the image-recording layer.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001277740 A
- JP 2001277742 A
- JP 2002287334 A
- US 20030064318 A
- JP 2009241257 A
- JP 2009517720 T
- JP 2008195018 A
- JP 9123387 A
- JP 9131850 A
- JP 9171249 A
- JP 9171250 A
- EP 931647 A
- JP 8108621 A
- JP 61166544 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2001133969 A
- JP 2002023360 A
- JP 2002040638 A
- JP 2002278057 A
- JP 2007090850 A
- JP 5005005 A
- JP 2001222101 A
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- US 3458311 A
- JP 55049729 B

- JP 2005250216 A
- JP 2006259137 A
- JP 2005119273 A

**Non-patent literature cited in the description**


- **S. I. SCHLESINGER.** *Photogr. Sci. Eng.,* 1974, vol. 18, 387
- **T. S. BAL et al.** *Polymer.,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh, Proc. Conf. Rad. Curing ASIA,* October 1988, 478
- Senryo Binran. The Society of Synthetic Organic Chemistry, 1970